# EUROPEAN PATENT SPECIFICATION

(11) **EP 4 353 560 B1**
(45) Date of publication and mention of the grant of the patent: **09.12.2026**
(21) Application number: 22855251.9
(22) Date of filing: 28.07.2022
(51) Int. Cl.: B60W 60/00, G05D 1/00, G06F 40/30, G05B 17/02, G05B 19/045, G05B 19/02, G06F 40/289, G06F 30/20

(54) **VEHICLE CONTROL METHOD AND APPARATUS**
VERFAHREN UND VORRICHTUNG ZUR FAHRZEUGSTEUERUNG
PROCÉDÉ ET APPAREIL DE COMMANDE DE VÉHICULE

(30) Priority: 09.08.2021 CN 202110906751; 12.01.2022 CN 202210033562
(43) Date of publication of application: 17.04.2024
(73) Proprietor: Yinwang Intelligent Technologies Co., Ltd., Shenzhen, Guangdong 518129 (CN)
(72) Inventor: LUO, Daxin, Shenzhen, Guangdong 518129 (CN); SONG, Sida, Shenzhen, Guangdong 518129 (CN); MA, Sha, Shenzhen, Guangdong 518129 (CN)
(74) Representative: Pfenning, Meinig & Partner mbB
(86) International application number: PCT/CN2022/108589
(87) International publication number: WO 2023/016268

(56) References cited:
- CN-A- 109 324 622
- CN-A- 112 329 208
- CN-A- 112 506 075
- CN-A- 113 212 454
- JP-A- 2017 187 856
- US-A1- 2021 053 569
- US-A1- 2021 110 484
- US-A1- 2021 240 190
- ZHANG QINGZHAO QZZHANG@UMICH EDU ET AL: "A Systematic Framework to Identify Violations of Scenario-dependent Driving Rules in Autonomous Vehicle Software", PROCEEDINGS OF THE ACM ON MEASUREMENT AND ANALYSIS OF COMPUTING SYSTEMS, ACMPUB27, NEW YORK, NY, USA, vol. 5, no. 2, 3 June 2021 (2021-06-03), pages 1 - 25, XP058976747, DOI: 10.1145/3460082

## Description

### CROSS-REFERENCE TO RELATED APPLICATIONS

### TECHNICAL FIELD

This application relates to the field of Internet of Vehicles technologies, and in particular, to a vehicle control method and apparatus.

### BACKGROUND

In the field of Internet of Vehicles technologies, when a vehicle supports an autonomous driving function, the vehicle automatically determines, in an autonomous driving process based on behavior data, whether the vehicle conducts a violation behavior, plans a route that complies with a rule, and controls traveling of the vehicle on a road based on the planned route. The vehicle needs to understand rule content, and perform, based on a corresponding understanding result, the foregoing operations of violation behavior determining and route planning. Therefore, the result of understanding the rule content by the vehicle plays an important role in accurately and safely implementing the autonomous driving function of the vehicle.

Currently, rules that the vehicle needs to comply with may be traffic rules or manually set behavior rules. These rules are usually described by using a natural language, and are not suitable for task understanding and task execution by a machine/program like an autonomous driving system (autonomous driving system, ADS). Therefore, modeling needs to be performed for content of the rules.

In the conventional technology, when modeling is performed on a rule, rule content described by using a natural language is generally converted into a digital rule described based on a proposition and an operator, or quantitative modeling is performed on the rule content to obtain a digital formula rule that constrains a behavior of an autonomous vehicle. Consequently, a calculation workload is excessively large, and correctness of the obtained digital rule cannot be ensured.
The following publication concerns a framework for identifying violations of scenario-dependent driving rules in autonomous vehicle software using formal methods: ZHANG QINGZHAO QZZHANG@UMICH EDU ET AL: "A Systematic Framework to Identify Violations of Scenario-dependent Driving Rules in Autonomous Vehicle Software", 3 June 2021.
US 2021/053569 A1 discloses a computer-implemented method comprising: determining, by a computer system, driving behavior of a plurality of manually-operated vehicles, each manually-operated vehicle having engaged in traffic merging behavior at a corresponding uncontrolled traffic intersection; determining, by the computer system, an autonomous vehicle driving model based on the driving behavior, the autonomous vehicle driving model describing an autonomous vehicle driving behavior to be implemented by an autonomous vehicle driving to merge with traffic at an uncontrolled traffic intersection; and operating, using a control circuit, the autonomous vehicle according to the autonomous vehicle driving model.

### SUMMARY

Embodiments of this application provide a vehicle control method, a computer-readable storage medium, a vehicle and a vehicle control apparatus, to obtain a target model by performing finite-state machine modeling on the target rule, and constrain a vehicle behavior by using the obtained target model. In this way, accuracy and safety of implementing a vehicle driving policy (for example, an autonomous driving policy) can be improved. The invention as claimed is defined in the independent claims.

According to a first aspect, an embodiment of this application provides a vehicle control method defined in claim 1. The method is applied to a vehicle control apparatus. The vehicle control apparatus may be an independent device, may be a chip or a component in a device, or may be a software module. The vehicle control apparatus may be deployed in a vehicle, a cloud, a roadside device, a remote server, a local server, or the like. A product form and a deployment manner of the vehicle control apparatus are not limited in this application.

The method includes: obtaining a target rule; obtaining a target model based on the target rule, where the target rule is associated with a candidate driving behavior of a vehicle, the target model includes a status information set and a conversion relationship information set, state information in the status information set describes a state that is of an association between the vehicle and another traffic participant and that corresponds to a case in which the vehicle conducts the candidate driving behavior, and conversion relationship information in the conversion relationship information set describes a conversion relationship between different association states; determining, based on the target model, target driving constraint information associated with the target rule, performing formal modeling on the target rule to obtain a formal model associated with the target rule, wherein the formal model comprises a formal statement, and the formal statement indicates whether the vehicle conducts the candidate driving behavior, or indicates whether the vehicle violates a rule when conducting the candidate driving behavior; and verifying the formal model based on the target model and/or the target driving constraint information that are/is associated with the target rule.

According to the foregoing method, a target model is obtained by performing finite-state machine modeling on a target rule, and target driving constraint information associated with the target rule can be obtained. The target driving constraint information may be used to determine a feasible driving behavior and an infeasible driving behavior of a vehicle, to control a vehicle behavior. In this way, accuracy and safety of implementing a vehicle driving policy (for example, an autonomous driving policy) can be improved. According to the method, descriptions of a state space (that is, a status information set) of a driving scenario of the target rule are relatively complete. This reduces a calculation workload in modeling calculation.

It should be noted that the "feasible driving behavior" described in this embodiment of this application may be a reasonable and compliant driving behavior of the vehicle in a driving scenario associated with the target rule. The "infeasible driving behavior" may refer to an unreasonable or incompliant driving behavior of the vehicle in the driving scenario associated with the target rule. It should be noted that whether the driving behavior of the vehicle in the driving scenario is feasible is relative, and is further related to real-time state information of the vehicle in a specific implementation. For example, if the target rule is a rule related to an action of lane change of the vehicle, and the target rule indicates "A distance from a rear vehicle in an adjacent lane always meets a safety distance requirement of [T] seconds in a process of performing an action of lane change", the action of lane change is a feasible driving behavior when a real-time safety distance between the vehicle and a rear vehicle in an adjacent lane meets the requirement of [T] seconds. If the real-time safety distance between the vehicle and the rear vehicle in the adjacent lane does not meet the requirement of [T] seconds, the action of lane change is an infeasible driving behavior.

With reference to the first aspect, in a possible implementation, the obtaining a target model based on the target rule includes: parsing the candidate driving behavior, and determining the state that is of the association between the vehicle and the another corresponding traffic participant and that corresponds to the case in which the vehicle conducts the candidate driving behavior, to obtain the status information set; determining, based on the status information set, relationship conversion between states that are of associations between the vehicle and different traffic participants and that correspond to cases in which the vehicle conducts different candidate driving behaviors, to obtain the conversion relationship information set; and obtaining the target model based on the status information set and the conversion relationship information set.

According to the foregoing method, the vehicle control apparatus may determine, by using a result of parsing the candidate driving behavior associated with the target rule, all possible association states of the vehicle in the driving scenario of the target rule. The state space (namely, the status information set) and a conversion relationship information set that correspond to the target rule are determined, to obtain a finite-state machine model. The vehicle control apparatus may describe state information in the status information set and conversion relationship information in the conversion relationship information set by using a formal language, to obtain a digital rule that can be understood by a program or a machine, so as to improve accuracy and security of implementing a vehicle driving policy (for example, an automatic driving policy).

With reference to the first aspect, in a possible implementation, the state that is of the association between the vehicle and the another traffic participant includes one or more of the following: a running state of a software module or a hardware module of the vehicle; a running state of a software module or a hardware module of the another traffic participant; an environment state of an environment in which the vehicle and the another traffic participant are located; and an association relationship between the software module or the hardware module of the vehicle and the software module or the hardware module of the another traffic participant.

According to the foregoing method, association states between the vehicle and other traffic participants in all possible cases may be described based on all possible cases in the driving scenario of the target rule, to obtain a relatively complete state space of the target rule.

With reference to the first aspect, in a possible implementation, the conversion relationship between different association states includes one or more of the following: a relationship of conversion from a first running state to a second running state by the software module or the hardware module of the vehicle; a relationship of conversion from a third running state to a fourth running state by the software module or the hardware module of the another traffic participant; a relationship of environment state conversion that is of the environment in which the vehicle and the another traffic participant are located and that is from a fifth state to a sixth state; and a relationship of conversion from a first association relationship to a second association relationship by the software module or the hardware module of the vehicle and the software module or the hardware module of the another traffic participant.

According to the foregoing method, all possible cases of conversion between different association states may be predicted and defined based on all possible cases in the driving scenario of the target rule, to help obtain a relatively complete conversion relationship set of the target rule.

With reference to the first aspect, in a possible implementation, the method further includes: obtaining a first candidate proposition and/or a first candidate operator from a target database; and describing the state information in the status information set and the conversion relationship information in the conversion relationship information set by using the first candidate proposition and/or the first candidate operator.

According to the foregoing method, the vehicle control apparatus may describe a target model (including the status information set and the conversion relationship set) based on a predefined proposition and/or operator. This helps improve a modeling speed and modeling efficiency.

With reference to the first aspect, in a possible implementation, the method further includes: obtaining at least one target constraint based on the target rule, where the at least one target constraint is used to control the candidate driving behavior associated with the target rule; and the determining, based on the target model, target driving constraint information associated with the target rule includes: determining, based on the at least one target constraint and/or the target model, the target driving constraint information associated with the target rule. Optionally, the at least one target constraint includes one or more of the following: a vehicle state constraint, a driving action constraint, or a safety distance constraint.

According to the foregoing method, the vehicle control apparatus may obtain target driving constraint information based on the at least one target constraint, to improve reasonableness and compliance of the target driving constraint information.

With reference to the first aspect, in a possible implementation, the method further includes: obtaining a second candidate proposition and/or a second candidate operator from the target database; and describing the at least one target constraint by using the second candidate proposition and/or the second candidate operator.

By using the foregoing method, the vehicle control apparatus may describe the target constraint by using a predefined proposition and/or operator. This helps to obtain a formally described target constraint. The at least one target constraint may also be used to assess whether a driving behavior of the vehicle violates a rule.

With reference to the first aspect, in a possible implementation, the method further includes: outputting control information of the vehicle based on the target driving constraint information.

According to the foregoing method, the vehicle control apparatus may plan a more reasonable and compliant driving policy for the vehicle based on the target driving constraint information.

With reference to the first aspect, in a possible implementation, the method further includes: outputting first indication information based on the target driving constraint information, where the first indication information indicates a safety level of a target driving policy of the vehicle and/or a safety level of a target driving behavior in the target driving policy.

According to the foregoing method, the vehicle control apparatus may perform safety assessment on a target driving policy of the vehicle based on the target driving constraint information, and formulate a more reasonable and compliant driving policy for the vehicle when determining that safety of the target driving policy or safety of a target driving behavior in the target driving policy is relatively poor.

As described above, according to the first aspect, the method includes: performing formal modeling on the target rule to obtain a formal model associated with the target rule, where the formal model includes a formal statement, and the formal statement indicates whether the vehicle conducts the candidate driving behavior, or indicates whether the vehicle violates a rule when conducting the candidate driving behavior; and verifying the formal model based on the target model and/or the target driving constraint information that are/is associated with the target rule.

According to the first aspect, the vehicle control apparatus performs, by using the target model and/or the target driving constraint information that are/is associated with the target rule, verification at different levels on the formal model associated with the target rule, to ensure correctness and completeness of the formal model.

With reference to the first aspect, in a possible implementation, the verifying the formal model based on the target model that is associated with the target rule includes: performing equivalence verification based on the target model and the formal model, where the equivalence verification is used to verify whether the state information in the status information set is equivalent to an output of the formal model.

By using the foregoing method, equivalence verification may be performed on the vehicle control model based on the target model and the formal model, to ensure consistency between an output of the formal model at a moment t and a state of a breaking rule variable in the target model.

With reference to the first aspect, in a possible implementation, the verifying the formal model based on the target driving constraint information that is associated with the target rule includes: verifying the formal model based on vehicle constraint information in the target driving constraint information, where the vehicle constraint information represents a condition for controlling the candidate driving behavior associated with the target rule, and/or represents a state that is of an association between the vehicle and a traffic participant.

By using the foregoing method, the vehicle control apparatus may verify the formal model based on the vehicle constraint information, to ensure that a driving policy obtained by using the formal model complies with a traffic rule.

With reference to the first aspect, in a possible implementation, the method further includes: outputting control information of the vehicle based on the formal model on which verification succeeds.

According to the foregoing method, the vehicle control apparatus may plan a more reasonable and compliant driving policy for the vehicle based on the formal model on which verification succeeds.

With reference to the first aspect, in a possible implementation, the method further includes: outputting second indication information based on the formal model on which verification succeeds, where the second indication information indicates a safety level of a target driving policy of the vehicle and/or a safety level of a target driving behavior in the target driving policy.

According to the foregoing method, the vehicle control apparatus may perform safety assessment on the target driving policy of the vehicle based on the formal model on which verification succeeds, to formulate a more reasonable and compliant driving policy for the vehicle when determining that safety of the target driving policy or the target driving behavior in the target driving policy is relatively poor.

According to a second aspect, an embodiment of this application provides a vehicle control apparatus configured to implement the foregoing method according to the first aspect or possible implementations.

According to a third aspect, a vehicle, where the vehicle includes a vehicle control apparatus according to the second aspect.

According to a fourth aspect, an embodiment of this application further provides a computer-readable storage medium. The computer-readable storage medium stores a computer program. When the computer program is run by a computer, the computer is enabled to perform the method according to the first aspect or possible implementations of the first aspect.

Based on the implementations provided in the foregoing aspects, the embodiments of this application may be further combined to provide more implementations, with embodiments according to the claimed invention being defined by the independent claims. For details about beneficial effects of the second aspect to the fourth aspect, refer to technical effects that can be achieved in the first aspect and the possible implementations of the first aspect. The details are not described herein again.

### BRIEF DESCRIPTION OF DRAWINGS

FIG. 1 is a schematic diagram of a system architecture to which an embodiment of this application is applicable;
FIG. 2 is a function block diagram of a vehicle control apparatus to which an embodiment of this application is applicable;
FIG. 3 is a schematic diagram of an architecture to which an embodiment of this application is applicable;
FIG. 4 is a schematic flowchart of a vehicle control method according to an embodiment of this application;
FIG. 5 is a schematic flowchart of a vehicle control method according to an embodiment of this application;
FIG. 6 is a schematic diagram of conversion between association states according to an embodiment of this application;
FIG. 7 is a schematic flowchart of a verification method according to an embodiment of this application;
FIG. 8 is a schematic flowchart of a verification principle according to an embodiment of this application;
FIG. 9 is a schematic diagram of a vehicle control apparatus according to an embodiment of this application; and
FIG. 10 is a schematic diagram of a vehicle control apparatus according to an embodiment of this application.

### DESCRIPTION OF EMBODIMENTS

In the field of Internet of Vehicles technologies, when a vehicle supports an autonomous driving function, the vehicle automatically determines, in an autonomous driving process based on behavior data, whether the vehicle conducts a violation behavior, plans a route that complies with a rule, and controls traveling of the vehicle on a road based on the planned route. The vehicle needs to understand rule content, and perform, based on a corresponding understanding result, the foregoing operations of violation behavior determining and route planning. Therefore, the result of understanding the rule content by the vehicle plays an important role in accurately and safely implementing the autonomous driving function of the vehicle.

Currently, rules that the vehicle needs to comply with may be traffic rules or manually set behavior rules. These rules are usually described by using a natural language, and are not suitable for task understanding and task execution by a machine/program like an autonomous driving system (autonomous driving system, ADS). Therefore, modeling needs to be performed for content of the rules.

Currently, common modeling schemes used for rule content modeling are classified into the following two types.

(1) In some solutions, in design of the ADS, design rules that are based on traffic rules (rule-based) are added to an autonomous driving planning and control module (planning and control module for short) of the ADS, to control a vehicle behavior and avoid driving violation of the vehicle. These design rules are digital rules generally formed by propositions and operators. The proposition is semantics (a concept actually expressed) of a statement, where the concept is a phenomenon that can be defined and observed. The operator is also referred to as a logical operator, and indicates an operation relationship between propositions.

The following is an example.

In the document of Abolfazl Karimi, Parasara Sridhar Duggirala, "Formalizing traffic rules for uncontrolled intersections", 2020 ACM/IEEE 11th International Conference on Cyber-Physical Systems (ICCPS), the natural language is used to describe a rule "At intersections without 'STOP' or 'YIELD' signs, yield to traffic and pedestrians already in the intersection or just entering the intersection (corresponding English text: At intersections without 'STOP' or 'YIELD' signs, yield to traffic and pedestrians already in the intersection or just entering the intersection), and the rule is converted to the following digital rule: 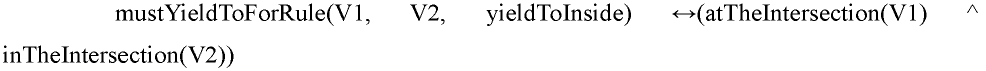 mustYieldToForRule(V1, V2, yieldToInside) ↔(atTheIntersection(V1) ^ inTheIntersection(V2))

In the digital rule, phrases such as "mustYieldToForRule", "V1, V2, yieldToInside", "atTheIntersection(V1)", and "inTheIntersection(V2)" that are named in a manner of camel case are propositions. A result of the proposition can be true (true) or false (false), indicating whether a phenomenon is valid or not. Connectives such as "↔" and "^" are operators (also referred to as logical operators), indicating "reasoning" and "AND" operations respectively.

During determining, the planning and control module first calculates a proposition result of each proposition in the foregoing digital rule. For example, a result of inTheIntersection(V2)=True(True) indicates that a vehicle V2 is in the intersection. Then, a result of the entire data rule is calculated, which is specifically true (True) or false (False), to indicate whether some phenomena in the digital rule are valid or not.

Simple digital rules such as waiting at a red traffic signal light, no speeding, and smooth lane change are easy to understand, and calculation is simple. However, for a complex scenario like traffic congestion, a quantity of related propositions or operators is large. In traversing a state space related to the digital rule (that is, a set of all possible states related to the digital rule), problems of an excessive calculation workload and incomplete traversing easily occur. This leads to "explosion" of the state space.

(2) In some solutions, for characteristics of autonomous driving, some rules that need to be complied with by an autonomous vehicle are defined by using a responsibility-sensitive safety (Responsibility-Sensitive Safety, RSS) model or a safety force field (Safety Force Field, SFF) model, and quantitative modeling is performed to form digital formula rules, so as to constrain a behavior of the autonomous vehicle.

For example, the RSS model defines the following rules.
(1) Do not hit a vehicle in front (vertical distance).
(2) Do not recklessly drive side by side with another vehicle (horizontal distance).
(3) Naturally obtain the right of way, but do not compete for the right of way.
(4) Drive with caution when sight is blocked.
(5) Avoid an accident when the accident can be avoided without causing another accident.

The RSS model defines and implements these rules, so that the autonomous vehicle can safely travel on a road, and it is considered that no traffic accident will be caused when all autonomous vehicles comply with these rules.

However, for modeling of the foregoing rules defined by the RSS model or the SFF model and application to the planning and control module, there is no specific requirement or specification, and reasonableness of the foregoing rules cannot be ensured. Therefore, when a driving policy of the autonomous vehicle is planned based on these rules, reasonableness of the obtained driving policy cannot be ensured.

Embodiments of this application provide a vehicle control method and apparatus. Finite-state machine modeling is performed on a rule to obtain a target model, and a vehicle behavior is constrained by using the obtained target model, to improve accuracy and safety of implementing a vehicle driving policy (for example, an autonomous driving policy). The method and the apparatus are based on a same concept. Because a problem-resolving principle of the method is similar to that of the apparatus, mutual reference may be made to implementations of the apparatus and the method. Repeated parts are not described in detail.

It should be noted that the vehicle control solution in embodiments of this application can be applied to the Internet of Vehicles, for example, vehicle to everything (vehicle to everything, V2X), a long term evolution-vehicle (long term evolution-vehicle, LTE-V) technology, or vehicle to vehicle (vehicle to vehicle, V2V). For example, the solution may be applied to a vehicle, or an in-vehicle apparatus having a driving function in a vehicle. The in-vehicle apparatus includes but is not limited to an in-vehicle terminal, an in-vehicle controller, an in-vehicle module, an in-vehicle assembly, an in-vehicle component, an automotive chip, an on board unit, an in-vehicle radar, an in-vehicle camera, or the like. A vehicle may implement the vehicle control method provided in this application with an in-vehicle apparatus. Certainly, the vehicle control solution in embodiments of this application may be further applied to another intelligent terminal than a vehicle, or disposed in another intelligent terminal than a vehicle, or disposed in a component of an intelligent terminal. The intelligent terminal may be another terminal device like an intelligent transportation device, a smart home device, a robot. For example, the intelligent terminal includes, but is not limited to, an intelligent terminal or a controller, a chip, a sensor like a radar or a camera, another component, and the like that are in the intelligent terminal. The intelligent terminal may implement, by connecting to the vehicle, the vehicle control method provided in embodiments of this application.

It should be noted that, in embodiments of this application, "at least one" means one or more, and "a plurality of" means two or more. The term "and/or" describes an association relationship between associated objects and represents that three relationships may exist. For example, A and/or B may indicate the following cases: Only A exists, both A and B exist, and only B exists, where A and B may be singular or plural. The character "/" usually indicates an "or" relationship between associated objects. "At least one of the following items (pieces)" or a similar expression thereof refers to any combination of the items, including any combination of singular items (pieces) or plural items (pieces). For example, at least one of a, b, or c indicates a, b, c, a and b, a and c, b and c, or a, b, and c, where a, b, and c may be singular or plural.

In addition, unless otherwise stated, ordinal numbers such as "first" and "second" in embodiments of this application are used to distinguish between a plurality of objects, but are not intended to limit priorities or importance of the plurality of objects.

For ease of understanding, the following describes technical solutions in embodiments of this application with reference to the accompanying drawings in embodiments of this application. It should be understood that the embodiments described below are merely some but not all of embodiments of this application.

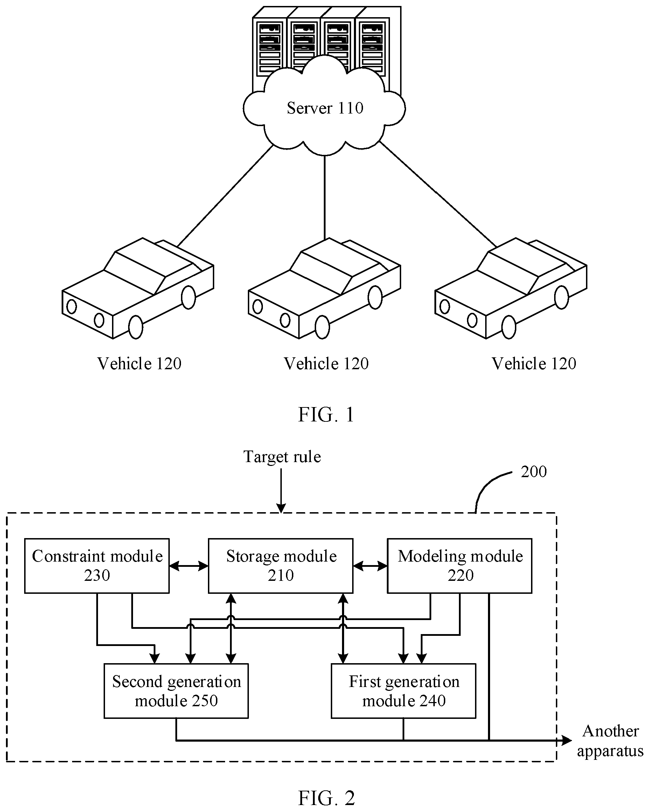

FIG. 1 is a schematic diagram of a system architecture to which an embodiment of this application is applicable. The system architecture shown in FIG. 1 includes a server 110 and a vehicle 120. The server 110 may be an apparatus, a component, or a chip that has a processing function, for example, may include a physical device like a host or a processor, or may include a virtual device like a virtual machine or a container, or may include a chip or an integrated circuit. In the Internet of Vehicles, the server 110 may be usually an Internet of Vehicles server, which is also referred to as a cloud server, a cloud, a cloud end, a cloud server, a cloud controller, or the like. The Internet of Vehicles server may be a single server, or may be a server cluster including a plurality of servers. This is not specifically limited. The vehicle 120 may be any vehicle having an autonomous driving function, including but not limited to a car, a lorry, a truck, a motorcycle, a bus, a boat, a plane, a helicopter, a lawn mower, an entertainment vehicle, an amusement park vehicle, a construction device, a tram, a golf cart, a train, a trolley, and the like. Usually, the vehicle 120 may be further registered with the server 110, to obtain various services provided by the server 110, such as a voice service, a navigation service, or a voice broadcast service.

It should be understood that a quantity of servers 110 and a quantity of vehicles 120 in the system architecture are not limited in this embodiment of this application. Usually, one server 110 may be simultaneously connected to a plurality of vehicles 120 (for example, simultaneously connected to three vehicles 120 shown in FIG. 1). In addition, besides the server 110 and the vehicle 120, the system architecture to which embodiments of this application are applicable may further include other devices, such as a core network device, a wireless relay device, and a wireless backhaul device. This is not limited in embodiments of this application. The server 110 in this embodiment of this application may integrate all functions into one independent physical device, or may separately deploy different functions on a plurality of independent physical devices. This is not limited in this embodiment of this application.

The vehicle control method in embodiments of this application may be implemented by a vehicle control apparatus. The vehicle control apparatus may be an independent device, or may be a chip or a component in a device, for example, the server 110 in FIG. 1, or the chip or component in the server 110, or the vehicle 120, or the chip or component in the vehicle 120. Alternatively, the vehicle control apparatus may be a software module, and may be deployed in the server 110, the vehicle 120, or another device on the vehicle 120. Alternatively, some functions of the vehicle control apparatus may be deployed in the server 110, and other functions are deployed in the vehicle 120. A product form, a deployment manner, and the like of the vehicle control apparatus are not limited in embodiments of this application. For ease of understanding and description, the following describes a vehicle control solution that can be implemented by the vehicle control apparatus by using an example in which the vehicle control apparatus is the server 110 or the vehicle 120.

For ease of understanding, the following first describes functions of the vehicle control apparatus.

FIG. 2 is a function block diagram of a vehicle control apparatus to which an embodiment of this application is applicable. Refer to FIG. 2. The vehicle control apparatus 200 may include a storage module 210, a modeling module 220, a constraint module 230, a first generation module 240, and a second generation module 250. The modules in the vehicle control apparatus 200 may collaborate to obtain, based on an obtained target rule, a target model, target driving constraint information, a target assert statement, and the like that are associated with the target rule. The target model, the target driving constraint information, and the target assert statement may be used to control driving of the vehicle, so as to improve accuracy and safety of implementing vehicle driving policies (for example, an autonomous driving policy).

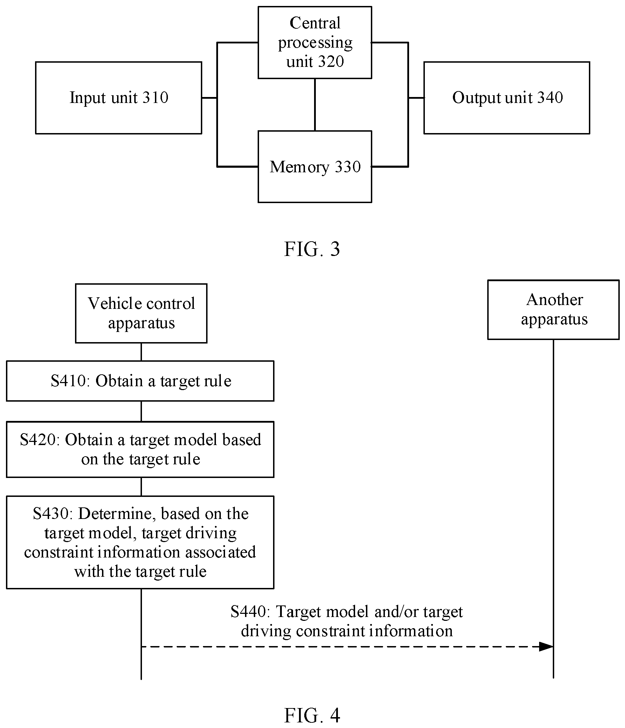

Optionally, refer to FIG. 3. The vehicle control apparatus 200 may use a Von Neumann architecture. The architecture may include an input unit 310, a central processing unit 320, a memory 330, and an output unit 340. The target rule may be input into the architecture by using the input unit 310. The central processing unit 320 may be configured to implement functions of the modeling module 220, the constraint module 230, the first generation module 240, and the second generation module 250 shown in FIG. 2. The memory 330 may be configured to implement a function of the storage module 210 in FIG. 2, and is configured to provide related information required for data processing for the central processing unit 320. The target model, the target driving constraint information, and the target assert statement that are obtained by the central processing unit 320 through processing may be stored in the memory 330, or may be output to another apparatus (for example, an ADS in the vehicle 120 or a planning and control module in the ADS) by using the output unit 340. It should be understood that, an example architecture of the vehicle control apparatus in this embodiment of this application is described herein, but this is not a limitation. In another embodiment, the vehicle control apparatus may be implemented by using another architecture. Details are not described herein again.

### (1) Storage module 210

The storage module 210 has a storage function, and may be configured to store information in any form, for example, a program, data processed by a program, or data obtained by executing a program. The storage module 210 may exchange information with at least one of other modules in the apparatus 200, for example, the modeling module 220, the constraint module 230, the first generation module 240, or the second generation module 250. The modeling module 220, the constraint module 230, the first generation module 240, or the second generation module 250 may obtain a related program or related data from the storage module 210 to implement respective functions. Related data generated by the modeling module 220, the constraint module 230, the first generation module 240, or the second generation module 250 for implementing respective functions may also be stored in the storage module 210. Optionally, the storage module 210 may further store the obtained target rule.

### (2) Modeling module 220

The modeling module 220 has a modeling function, and is configured to establish a target model for the target rule. The modeling module 220 performs formal modeling on the target rule to obtain a formal model associated with the target rule.

The target rule may be any one of a plurality of rules that the vehicle needs to comply with, or may be a rule associated with a current driving behavior of the vehicle. Content of the target rule may be described by using a natural language, and the target rule may be associated with at least one candidate driving behavior of the vehicle. The target model may be a model obtained by the modeling module 220 by understanding and modeling (modeling) content of the target rule. The target model may be a finite-state machine (Finite-state machine, FSM) model. The state machine model may include a status information set and a conversion relationship information set. The status information set may include a limited quantity of pieces of state information. Any piece of state information may be used to describe a state that is of an association between the vehicle and another traffic participant and that corresponds to a case in which the vehicle conducts a candidate driving behavior. The conversion relationship information set may include a limited quantity of pieces of conversion relationship information. Any piece of conversion relationship information is used to describe a conversion relationship between different association states. The formal model is a model constructed by using a formal method (formal method). The formal model includes a formal statement that indicates whether the vehicle conducts a candidate driving behavior associated with the target rule, or indicates whether the vehicle violates a rule when conducting the candidate driving behavior. The target model may be deployed on the vehicle to control driving of the vehicle. The target model is used to perform formal verification on the formal model. A formal model on which verification succeeds may be deployed on the vehicle to control driving of the vehicle. The following provides detailed descriptions with reference to the accompanying drawings and embodiments. Details are not described herein.

During implementation, the modeling module 220 may parse the at least one candidate driving behavior, and determine a state that is of an association between the vehicle and another corresponding traffic participant and that corresponds to a case in which the vehicle conducts each candidate driving behavior, to obtain the status information set; determine, based on the status information set, a conversion relationship between states that are of associations between the vehicle and different traffic participants and that correspond to cases in which the vehicle conducts different candidate driving behaviors, to obtain the conversion relationship information set; and obtain the target model based on the status information set and the conversion relationship information set.

It should be noted that, in this embodiment of this application, when the vehicle conducts a candidate driving behavior, another traffic participant corresponding to the candidate driving behavior may include any traffic participant that may have an association relationship with the vehicle before, during, and after conduction of the candidate driving behavior. There may be one or more traffic participants corresponding to the candidate driving behavior. For example, for a candidate driving behavior "the vehicle changes lane to the left", another corresponding traffic participant may include: a first lane on which the vehicle is located before the vehicle conducts the behavior of changing lane to the left; a left lane line of the first lane; a second lane (that is, a left adjacent lane of the first lane) on which the vehicle is located after the vehicle conducts the behavior of changing lane to the left; and another vehicle, pedestrian, or traffic facility around the vehicle before, during, and after conduction of the behavior of changing lane to the left by the vehicle. At a same moment, states of associations between the vehicle (or a software module or hardware module in the vehicle) and other different traffic participants (or software modules or hardware modules of the traffic participants) may be the same or different. Relationship conversion between states that are of associations between the vehicle and different traffic participants and that correspond to cases in which the vehicle conducts different candidate driving behaviors includes relationship conversion between states that are of associations between the vehicle (or a software module or hardware module in the vehicle) and other different traffic participants (or a software module or hardware module of the traffic participant) before or after conduction of a candidate driving behavior by the vehicle and during conduction of different candidate driving behaviors by the vehicle. This is not limited in this embodiment of this application.

For example, a state of an association between the vehicle and another traffic participant may include but is not limited to the following states.

### (1-1) A running state of a software module or a hardware module of the vehicle

The software module of the vehicle may include various software modules that may be equipped on the vehicle, for example, an adaptive cruise control (Adaptive Cruise Control, ACC) module configured to implement intelligent driving assistance, a lane keeping assist (Lane Keeping Assist, LKA) module, an autonomous emergency braking (Autonomous Emergency Braking, AEB) module, a traffic jam assistant (Traffic Jam Assistant, TJA) module, an electronic power steering (Electronic Power Steering, EPS) system, an electronic stability program (Electronic Stability Program, ESP) system, an anti-lock break system (Anti-lock Break System, ABS), or an engine management system (Engine Management System, EMS). The running state of the software module may include a running state of each software module, for example, an enabled state, an activated state, or a disabled state, and a related state corresponding to a case in which the software module is in any one of the enabled state, the activated state, the disabled state, or the like.

The hardware module of the vehicle may include various hardware modules that may be disposed on the vehicle, for example, an energy source (for example, a battery or a fuel tank), an engine, a wheel, a steering wheel, a throttle, a vehicle light (for example, a headlight, a taillight, or a turn signal), a brake (commonly referred to as a brake), a human machine interface (Human Machine interaction, HMI), a microphone, a speaker, a sensor (for example, a camera, a millimeter wave radar, a lidar, a wheel speed sensor, or an acceleration sensor). The running state of the hardware module may include a running state of each hardware module, for example, a running state of the energy source, for example, a battery level or a fuel volume in the fuel tank; a running state of the engine, for example, an disabled state or an operating state; a running state of the wheel, for example, a wheel speed (that is, a vehicle speed) or a wheel direction; a running state of the steering wheel, for example, forward, leftward deflection of a first angle, or rightward deflection of a second angle; a running state of the throttle: an open angle; a running state of the vehicle light, for example, a single vehicle light is turned off/on, or a combination of some vehicle lights is turned on/off; a running state of the brake: for example, a braking torque change; a running state of the HMI, for example, display of a picture; a running state of the microphone: voice collection by the microphone; a running state of the speaker, for example, the speaker plays voice; and a running state of the sensor: various sensing information collection by the camera, the millimeter wave radar, the lidar, the wheel speed sensor, the acceleration sensor, or the like. It should be understood that, in this embodiment of this application, the entire vehicle may also be considered as a hardware module of the vehicle.

### (1-2) A running state of a software module or a hardware module of the another traffic participant

The another traffic participant may include any traffic participant other than the vehicle in an environment in which the vehicle is located, including but not limited to, a current lane of the vehicle and a lane line of the current lane; a vehicle ahead of the vehicle and a rear vehicle of the vehicle in the current lane; a lane adjacent to the current lane and a lane line of an adjacent lane; several vehicles on the adjacent lane; a pedestrian on the current lane, or the adjacent lane, or a road intersection; and various traffic facilities such as a pedestrian crosswalk, road side unit (Road Side Unit, RSU), a traffic signal light (for example, a vehicle signal light, a non-motor vehicle signal light, a pedestrian crosswalk light, a direction signal light, a lane signal light, a flash signal light, and a signal light at a road-railway crossing), a fence, a lighting facility, a line-of-sight guidance sign, a road reflector, and a road information board.

The software module of the another traffic participant may include various software modules that may be equipped by the another traffic participant, for example, a software module (for details, refer to the foregoing related descriptions of the vehicle software module, and the details are not described herein) equipped on another vehicle (including a vehicle ahead of the vehicle, a rear vehicle of the vehicle, and several other vehicles on an adjacent lane of a current lane); a software module equipped in the RSU to control the RSU to perform traffic communication with a vehicle passing the RSU; and a timing control module/sensing control module/adaptive control module configured in the traffic signal light to control light change. The running state of the software module may include a running state of the software module itself, for example, a control state and a communication state, and a related state corresponding to a case in which the software module is in the control state and the communication state.

The hardware module of the another traffic participant may include various hardware modules that may be equipped by the another traffic participant, for example, a hardware module (for details, refer to the foregoing related descriptions of the vehicle hardware module, and the details are not described herein) equipped on another vehicle (including a vehicle ahead of the vehicle, a rear vehicle of the vehicle, and several other vehicles on an adjacent lane of a current lane); a sensor module of a road side unit; and different signal lights of a traffic signal light. In some cases, the hardware module of the another traffic participant may be an entity of the another traffic participant itself, for example, the pedestrian, the lane, the lane line, the pedestrian crosswalk, the fence, the lighting facility, the line-of-sight guidance sign, the road reflector, and the road information board. The running state of the hardware module may include running states of the hardware modules, for example, a running state of the hardware module of the another vehicle (for details, refer to the foregoing related description of the running state of the hardware module of the vehicle, and the details are not described herein); sensing information collection by the sensor module of the road side unit; display status conversion between different signal lights of the traffic signal light; and a lane traffic state: open, closed, and limited. When the hardware module of the another traffic participant is the entity of the another traffic participant, the running state of the hardware module of the another traffic participant may remain unchanged within a preset time. For example, a fixed traffic facility (for example, a vehicle, a lane line, a pedestrian crosswalk line, a fence, a lighting facility, a line-of-sight guidance sign, and a road reflector) on a road usually remains in a same running state within a preset working time.

It should be understood that, in this embodiment of this application, traffic participation of the vehicle or another traffic participant may be active traffic participation, or may be passive traffic participation, or may be active and passive traffic participation. For example, active traffic participation may include but is not limited to: movement of a pedestrian in a lane or at a road intersection, traveling of a vehicle, control over vehicle traveling by a traffic signal light through changing a display state of the traffic signal light, traffic communication by an RSU with a passing vehicle, illumination by a roadside lighting facility for a passing vehicle, guiding vehicle traveling by a road information board with different displayed road information. Passive traffic participation may include but is not limited to the following case: A current lane participates in traffic when a vehicle is in a current lane. A lane line participates in traffic when the vehicle presses a lane line. A lighting facility, a line-of-sight guidance sign, and a road reflector participate in traffic when a vehicle passes the lighting facility, the line-of-sight guidance sign, and the road reflector on a road side. The foregoing traffic participants other than a vehicle driver, the vehicle, and the another vehicle may also be referred to as a road side device.

It should be noted that the foregoing describes merely examples of other possible traffic participants and a software module and a hardware module of other traffic participants in this embodiment of this application, and do not constitute any limitation. In another embodiment, any object participating in traffic other than a vehicle may be considered as the another traffic participant in this embodiment of this application. In addition, a configuration of the software module or the hardware module of the another traffic participant is related to a function of the another traffic participant, and any other traffic participant may include a software module and/or a hardware module.

### (1-3) An environment state of an environment in which the vehicle and the another traffic participant are located

The environment state may include, for example, but is not limited to: a weather state like sunny, raining (including shower, light rain, heavy rain, rainstorm, and the like), cloudy, and snowy; a road surface state like dry, waterlogged, frozen, and shaded; a road surface material like cement, asphalt, and mud; a road type like a highway, a city road, a ramp, and non-motorized vehicle lane; and a traffic state like traffic jam, traffic control, and traffic accident.

### (1-4) An association relationship between the software module or the hardware module of the vehicle and the software module or the hardware module of the another traffic participant

The association relationship may include an association relationship between the software module of the vehicle and the software module of the another traffic participant, an association relationship between the software module of the vehicle and the hardware module of the another traffic participant, an association relationship between the hardware module of the vehicle and the software module of the another traffic participant, and an association relationship between the hardware module of the vehicle and the hardware module of the another traffic participant. It should be understood that, herein, an association relationship between the software module or the hardware module of the another traffic participant and a combination of the software module and the hardware module of the vehicle is not excluded, and an association relationship between the software module or the hardware module of the vehicle and a combination of the software module and the hardware module of the another traffic participant is not excluded. These association relationships may be specifically association relationships between running states of software modules or hardware modules of different traffic participants.

For example, a conversion relationship between different association states may include but is not limited to the following conversion relationships.

### (2-1) A relationship of conversion from a first running state to a second running state by the software module or the hardware module of the vehicle

Conversion between the first running state and the second running state may be running state conversion based on a time/location or the like of the software module or the hardware module of the vehicle.

The software modules of the vehicle are used as examples. Based on time, the first running state may include, for example, a running state of the software modules of the vehicle (for example, at least one of the ACC module, the LKA module, the AEB module, the TJA module, the EPS system, the ESP system, the ABS, or the EMS system) at a first time, and the second running state may include, for example, a running state of the software modules of the vehicle at a second time. The second time is later than the first time. The first running state being the same as the second running state indicates that the running state of the software module of the vehicle remains unchanged in an interval from the first time to the second time. The first running state being different from the second running state indicates that the running state of the software module changes. For example, the ACC module changes from a non-ACC state to an ACC state, or the ACC module in the ACC state changes from a first cruise speed to a second cruise speed, or the ACC module changes from the ACC state to the non-ACC state. Other software modules of the vehicle have a similar running state conversion relationship. Details are not described herein again.

The hardware modules of the vehicle are used as examples. Based on time, the first running state may include a running state of the hardware modules (for example, at least one of the energy source, the engine, the wheel, the steering wheel, the throttle, the vehicle light, the brake, the HMI, the microphone, the speaker, and the various sensors) of the vehicle at a first time, and the second running state may include, for example, a running state of the hardware modules of the vehicle at a second time. The second time is later than the first time. The first running state being the same as the second running state indicates that the running state of the hardware module of the vehicle remains unchanged in an interval from the first time to the second time. The first running state being different from the second running state indicates that the running state of the hardware module changes. For example, a vehicle light (for example, a headlight, a taillight, or a turn light) is switched from an off state to an on state or from the on state to the off state. Other hardware modules of the vehicle have a similar running state conversion relationship. Details are not described herein again.

### (2-2) A relationship of conversion from a third running state to a fourth running state by the software module or the hardware module of the another traffic participant

Conversion from the third running state to the fourth running state may be running state conversion based on a time, a location, or the like of the software module or the hardware module of the another traffic participant. Meanings of the third running state and the fourth running state are the same as or similar to those of the first running state and the second running state. For similarities, refer to the foregoing related descriptions. Details are not described herein again.

### (2-3) A relationship of environment state conversion that is of an environment in which the vehicle and the another traffic participant are located and that is from a fifth state to a sixth state

Conversion from the third running state to the fourth running state may be running state conversion based on a time, a location, or the like of the software module or the hardware module of the another traffic participant. Meanings of the fifth state and the sixth state are the same as or similar to those of the first running state and the second running state. For similarities, refer to the foregoing related descriptions. Details are not described herein again.

### (2-4) A relationship of conversion from a first association relationship to a second association relationship by the software module or the hardware module of the vehicle and the software module or the hardware module of the another traffic participant

The first association relationship and the second association relationship may also be association relationships based on a time, a location, or the like.

For example, the another traffic participant is a current road that the vehicle is on. In a driving process of the vehicle, the first association relationship may include association relationships between a current lane and the software modules or the hardware modules of the vehicle at a third time (differentiated from the foregoing first time), and the second association relationship may include association relationships between the current lane and the software modules or the hardware modules of the vehicle at a fourth time (differentiated from the foregoing second time). The fourth time is later than the third time. The first association relationship and the second association relationship being the same indicates that the association relationship of the software module/hardware module of the vehicle remains unchanged in an interval from the third time to the fourth time. The first association relationship and the second association relationship being different indicates that the association relationship of the software module/hardware module of the vehicle changes in the interval from the third time to the fourth time. The ACC module is still used as an example. The association relationship changes, for example, the vehicle switches from the non-ACC state to the ACC state on the current road, or the vehicle in the ACC state switches from a third cruise speed to a fourth cruise speed on the current road, or the vehicle switches from the ACC state to the non-ACC state on the current road. An association relationship between another software module or hardware module of the vehicle and the current road is similar to the relationship described above. Details are not described herein again. It should be understood that when the current road in this example is replaced with the software module or hardware module of the foregoing another traffic participant, meanings of the first association relationship and the second association relationship are the same as or similar to the meanings described above.

### Details are not described herein again.

Further, in embodiments of this application, in addition to the candidate driving behavior of the vehicle, the target rule may be associated with various possible information like a candidate driving scenario, a candidate traffic participant, a candidate driving parameter, or a candidate constraint of the vehicle. The association may be direct association, for example, the association is described in the content of the target rule. Alternatively, the association may be indirect association, for example, the association needs to be understood and predicted based on the content of the target rule. Optionally, the modeling module 220 may include a status description module 221. The status description module 221 may parse the content of the target rule, and predict all possible association states that are of the vehicle and that are related to the candidate driving scenario, the candidate driving behavior, and the candidate traffic participant that are associated with the target rule. The status description module 221 may describe each association state by using a formal language, to obtain a status information set. Optionally, the modeling module 220 may further include a status conversion implementation module 222. The state conversion implementation module 222 may determine a relationship of conversion between different association states in the status information set based on a parsing result of the content of the target rule. The state conversion implementation module 222 may further describe each piece of conversion relationship information by using a formal language, to obtain a conversion relationship information set.

### (3) Constraint module 230

The constraint module 230 may be configured to obtain at least one target constraint based on a target rule, where the at least one target constraint is used to control a candidate driving behavior associated with the target rule.

In this embodiment of this application, the at least one target constraint may be a feasibility constraint for the candidate driving behavior associated with the target rule conducted when the vehicle is in a traffic scenario associated with the target rule. For example, the at least one target constraint may include one or more of the following: a vehicle state constraint, a driving action constraint, or a safety distance constraint, which may be respectively used to control conditions that need to be met and that indicate a vehicle state, a driving action, a safety distance, or the like corresponding to a case in which the vehicle is allowed to conduct the candidate driving behavior related the target rule.

For example, the vehicle state may include a speed of the vehicle. If the target rule indicates that a maximum speed of the vehicle is 60 km/h, the vehicle state constraint may include: speed V≤60 km/h. For another example, the driving action may include an action of changing lane to the left by the vehicle. If the target rule indicates that the vehicle is prohibited from changing lane to the left, the driving action constraint may include prohibition on changing lane to the left. For another example, the safety distance includes a distance headway between the vehicle and a vehicle ahead. If the target rule indicates that the distance headway between the vehicle and the vehicle ahead is not greater than 10 m, the safety distance constraint may include: distance headway S1≤10 m. For another example, the safety distance includes a horizontal distance between a vehicle and another vehicle on an adjacent lane. If the target rule indicates that a horizontal lane-change distance between the vehicle and the another vehicle is not greater than 5 m, the safety distance constraint may include: horizontal distance S2≤5 m. For another example, the safety distance may be measured by using a time interval. If the target rule indicates that the safety distance between the vehicle and the vehicle ahead is a safety distance requirement of [T] seconds, the safety distance constraint may include: Dist≤T seconds.

It should be understood that the target constraint is simply described but not limited herein by using the vehicle state, the driving action, the safety distance, and the like as examples. In different traffic scenarios, the target constraint may further have different meanings. The following describes the target constraint in detail with reference to the accompanying drawings and embodiments. Details are not described herein again.

### (4) First generation module 240/Second generation module 250

A target model output by the modeling module 220 and/or at least one target constraint output by the constraint module 230 may be separately used as an input, and provided to the first generation module 240 or the second generation module 250. Further, the first generation module 240 may generate, based on the target model and the at least one target constraint, the target driving constraint information associated with the target rule. The second generation module 250 may generate, based on the target model and the at least one target constraint, a target assert statement associated with the target rule. At least one of the target model, the target driving constraint information, or the target assert statement may be stored in the storage module 210 while associated with the target rule. At least one of the target model, the target driving constraint information, or the target assert statement may be provided as an output to another apparatus than the vehicle control apparatus 200, so that the another apparatus may implement driving control on the vehicle based on the at least one of the target model, the target driving constraint information, or the target assert statement.

In this embodiment of this application, in a possible implementation, the vehicle control apparatus 200 may be deployed in the server 110, and at least one of the target model, the target driving constraint information, or the target assert statement may be provided for the ADS of the vehicle 120. Further, based on at least one of the target model, the target driving constraint information, or the target assert statement, the ADS may implement driving control on the vehicle, or assess a security level of a target driving policy of the vehicle or a security level of a target driving behavior in the target driving policy.

For example, the ADS may perform, based on at least one of the target model, the target driving constraint information, or the target assert statement, formal verification on a digital rule or another rule model that is of the target rule and that is obtained in another manner, to verify correctness and completeness of the digital rule or the another rule model. For another example, the ADS may formulate the target driving policy for the vehicle based on the target driving constraint information, and output the control information of the vehicle. For another example, the ADS may assess, based on the target driving constraint information, safety of the target driving policy formulated by the ADS for the vehicle, and output first indication information, where the first indication information indicates a safety level of the target driving policy of the vehicle and/or a safety level of a target driving behavior in the target driving policy. In this way, the ADS can plan a more reasonable and compliant driving policy for the vehicle based on the target driving constraint information. In another possible implementation, the vehicle control apparatus 200 may be deployed in the vehicle 120, and may be a component in the ADS. At least one of the target model, the target driving constraint information, or the target assert statement may be provided for a planning and control module in the ADS of the vehicle 120, to indicate the planning and control module to formulate an autonomous driving policy, determine a violation behavior of the vehicle, or verify correctness and completeness of a related design rule in the planning and control module. The following provides descriptions with reference to the accompanying drawings and embodiments. Details are not described herein.

In this embodiment of this application, to accelerate a modeling progress of the target model, in a possible implementation, the storage module 210 (or referred to as a target database) may store a plurality of propositions and/or a plurality of operators pre-defined based on a formal statement. The modeling module 220 (or specifically, the status description module 221 and the status conversion implementation module 222) may obtain a first candidate proposition and/or a first candidate operator from the storage module 210, describe state information in the status information set and conversion relationship information in the conversion relationship information set by using the first candidate proposition and/or the first candidate operator.

It should be noted that, in this embodiment of this application, the plurality of propositions and/or the plurality of operators stored in the storage module 210 may be implemented based on a computer program or implemented in another manner. The implementation is not limited in this embodiment of this application. The target database may be a relational database or a non-relational database. This is not limited in this embodiment of this application.

For example, the plurality of operators stored in the storage module 210 may include but are not limited to:
(1) "¬", indicating a "negation" operation;
(2) "^", indicating a "conjunction" operation;
(3) "v", indicating a "disjunction" operation;
(4) "→", indicating a "deduction or implication" operation;
(5) "U", indicating an "until" operation;
(6) "G", indicating an "always" operation; and
(7) "F", indicating a "finally" operation.

For example, the plurality of propositions stored in the storage module 210 may include but are not limited to the following propositions.
(1) stWeather(Rain): indicates whether it is rainy currently. If a calculation result of the proposition is true, that is, stWeather(Rain)=True, it indicates that it is rainy currently. If the calculation result of the proposition is false, that is, stWeather(Rain)=Flase, it indicates that it is not rainy currently.
(2) stObjPosition(Obj, Ego, Ahead): indicates whether a target object is located in front of an ego vehicle. If a calculation result of the proposition is true, that is, stObjPosition(Obj, Ego, Ahead)=True, it indicates that the target object is located in front of the ego vehicle. If the calculation result of the proposition is false, that is, stObjPosition(Obj, Ego, Ahead)=Flase, it indicates that the target object is not located in front of the ego vehicle.
(3) stCrossingLine(Ego, Left): indicates whether the ego vehicle changes lane to the left. If a calculation result of the proposition is true, that is, stCrossingLine(Ego, Left)=True, it indicates that the ego vehicle changes lane to the left. If the calculation result of the proposition is false, that is, stCrossingLine(Ego, Left)=Flase, it indicates that the ego vehicle does not change lane to the left.

Optionally, the storage module 210 may further store at least one piece of the following attribute information of each proposition.
(1) Proposition category: for example, propositions in an infrastructure category, an environment category, a state (for example, a running state of the vehicle and any other traffic participant) category, a driving behavior category, a time/location-based association relationship category, and the like.
(2) Proposition level: level-1 proposition, level-2 proposition, level-3 proposition, or the like. Propositions of different levels can be in parallel, or a higher-level proposition may contain a lower-level proposition.
(3) Proposition description: description of a function of a proposition, that is, explanation of the proposition.
(4) Proposition implementation: description of an implementation of a proposition, for example, which language is used to describe the proposition and how to describe a phenomenon.
(5) Proposition calculation result: may be, for example, a Bool value or another type of data like int.

In an implementation, the status description module 221 may obtain, through parsing with an automation tool or a manual operation (for example, keyword extraction or a neural network), a state that is of an association between the vehicle and another traffic participant and that corresponds to each moment in the target rule, and obtain a state space of the target rule through combination. The status description module 221 may traverse all possible association states in the target rule, obtain, from the storage module 210 (that is, the target database), first candidate propositions and/or the first candidate operators for describing all the possible association states of the target rule, and describe the state information in the status information set by using the first candidate propositions and/or the first candidate operators. The status information set may also be referred to as a state space dictionary, and may include a related candidate proposition corresponding to each moment and each association state and a calculation result of the candidate proposition. The status conversion implementation module 222 may determine conversion relationships between different association states in the status information set based on content of the target rule, and then obtain the conversion relationship information set. The target model can be obtained based on the status information set and the conversion relationship information set. The constraint module 230 may obtain, from the storage module 210 (that is, the target database), all second candidate propositions and/or second candidate operators that constrain a vehicle state, a driving action, a safety distance, and the like and that are related to the target rule, and describe the at least one target constraint by using the second candidate proposition and/or the second candidate operator.

Generally, the first candidate proposition may be the foregoing proposition in the infrastructure category, state category, driving behavior category, time/location-based association relationship category, or the like, and may be used to describe an association state. The first candidate operator may be any operator that may be required for connecting different first candidate propositions. The second candidate proposition may be the foregoing proposition in the environment category, and may a proposition describes a related situation constraining a vehicle state, a driving action, a safety distance, and the like. The second candidate operator may be any operator that may be required for connecting different second candidate propositions.

In an implementation, the status description module 221 and the status conversion implementation module 222 may directly describe the association state and the conversion relationship information based on the first candidate proposition and/or the first candidate operator, and calculate a result of each piece of formally described association state or conversion relationship information. The constraint module 230 may determine, based on a calculation result of the second candidate proposition and/or the second candidate operator in a scenario of the target rule, a target constraint corresponding to the target rule.

For example, if calculation is performed, based on the target rule, on a proposition in the environment category, namely, stWeather(Rain), and a result indicating stWeather(Rain)=True is obtained, this indicates that it is rainy currently. Correspondingly, if a related traffic specification indicates that a maximum speed of a vehicle on a road on a rainy day is 60 km/h, it can be learned that a target constraint corresponding to the target rule includes: speed V≤60 km/h. For another example, if a result obtained by performing calculation on a proposition in the environment category, namely, stProperDist(TimeObj), based on the target rule is true, it indicates that a safety distance constraint needs to be considered in a current scenario. Correspondingly, if a related traffic specification indicates that a safety distance T equals 3 seconds, it can be learned that a target constraint corresponding to the target rule includes: Dist≥3s.

Therefore, by using the vehicle control apparatus shown in FIG. 2, the target model is obtained by performing finite-state machine modeling on the target rule, and a vehicle behavior is constrained by using at least one of the obtained target model, the target driving constraint information associated with the target model, and the target assert statement, to improve accuracy and safety of implementing a vehicle driving policy (for example, an autonomous driving policy).

The following describes a vehicle control method according to an embodiment of this application with reference to FIG. 4. The vehicle control method may be implemented by the vehicle control apparatus 200 shown in FIG. 2.

As shown in FIG. 4, the vehicle control method includes the following steps.

S410: A vehicle control apparatus obtains a target rule.

In this embodiment of this application, the rule may be a traffic specification, or may be a manually set behavior specification that needs to be complied with by a vehicle. Content of the rule may be described by using a natural language. The rule may be associated with various association information about traffic participation of the vehicle, including but not limited to association to a candidate driving scenario, a candidate driving behavior, a candidate traffic participant, a candidate driving parameter, a candidate constraint, or the like. It should be noted that the various association information about traffic participation of the vehicle may be directly indicated in plaintext in the content of the target rule or indirectly determined by the vehicle control apparatus through parsing the content of the rule, or some pieces of the association information may be directly indicated in plaintext in the content of the rule, or some pieces of the association information are indirectly determined based on the content of the rule. This is not limited in this embodiment of this application.

For example, a rule 1 may be "At intersections without 'STOP' or 'YIELD' signs, yield to traffic or pedestrians already in the intersection or just entering the intersection". "Intersections without 'STOP' or 'Yield' signs" may be considered as a candidate driving scenario. "Yield to XXX" may be considered as a candidate driving behavior of the vehicle. "Traffic or pedestrians already in the intersection or just entering the intersection" may be considered as a candidate traffic participant.

For another example, a rule 2 may be "A distance from a rear vehicle in an adjacent lane always meets a safety distance requirement of [T] seconds in a process of performing an action of lane change". "Lane change" may be considered as a candidate driving scenario of the vehicle. "Action of lane change" may be considered as a candidate driving behavior of the vehicle. "Adjacent lane" and "rear vehicle" may be considered as candidate traffic participants. "Safety distance" may be considered as a candidate driving parameter. "[T] seconds" may be considered as a candidate constraint.

It should be noted that, the foregoing only uses the rule 1 and the rule 2 as examples rather than limitations to describe information that may be associated with the rules. Usually, each rule may also be associated with other information that is not explicitly described in the content of the rule. For example, the rule 1 may further be associated with another candidate traffic participant like a pedestrian crosswalk line. For example, the rule 2 may further be associated with another traffic participant, for example, a left lane line or a right lane line of a current lane of the vehicle.

**In** this embodiment of this application, when S410 is implemented, the vehicle control apparatus may obtain the target rule from a traffic department, a server, another apparatus, or another module of the vehicle. Based on different application scenarios of the vehicle control method, the target rule may be any one of a plurality of rules that the vehicle needs to comply with, or a rule associated with a current driving behavior of the vehicle, or a rule associated with a target driving behavior of the vehicle. In different cases, the vehicle control apparatus may perform different processing on the target rule. For ease of understanding and description, the following describes the vehicle control method in this embodiment of this application by using the rule 2 as the target rule obtained in S410.

S420: The vehicle control apparatus obtains a target model based on the target rule.

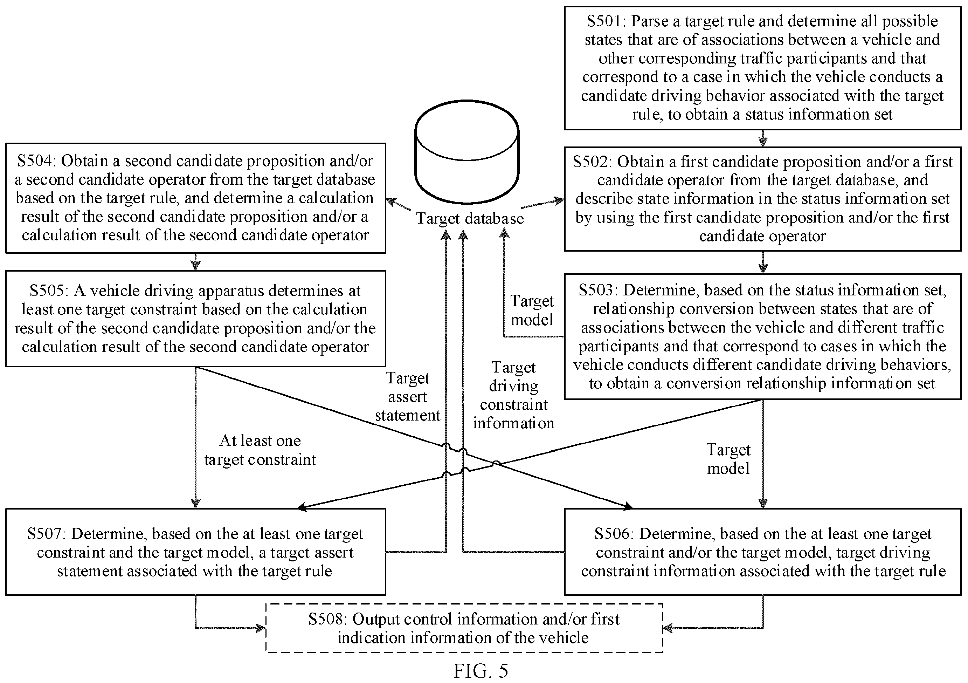

Refer to FIG. 5. Implementation of S420 may include the following steps.

S501: The vehicle control apparatus parses the target rule, and predicts all possible states that are of associations between the vehicle and other corresponding traffic participants and that correspond to a case in which the vehicle conducts the candidate driving behavior associated with the target rule, to obtain a status information set.

As described above, the target rule may be directly or indirectly associated with various association information like a candidate driving scenario, a candidate driving behavior, a candidate traffic participant, a candidate driving parameter, and a candidate constraint. Therefore, it should be noted that, when the target rule is parsed in S501, various association information associated with the target rule needs to be parsed, so as to predict possible association states of the target rule as many as possible, and obtain a relatively complete status information set of the target rule.

S502: The vehicle control apparatus obtains a first candidate proposition and/or a first candidate operator from a target database, and describes state information in the status information set by using the first candidate proposition and/or the first candidate operator.

The target database may store a plurality of predefined propositions and/or operators, and the plurality of propositions and/or operators may be used to describe states of an environment or a scenario. When implementing S502, the vehicle control apparatus may obtain, from the target database, the first candidate proposition and/or the first candidate operator used for describing the state information in the status information set, and describes the state information in the status information set by using the first candidate proposition and/or the first candidate operator.

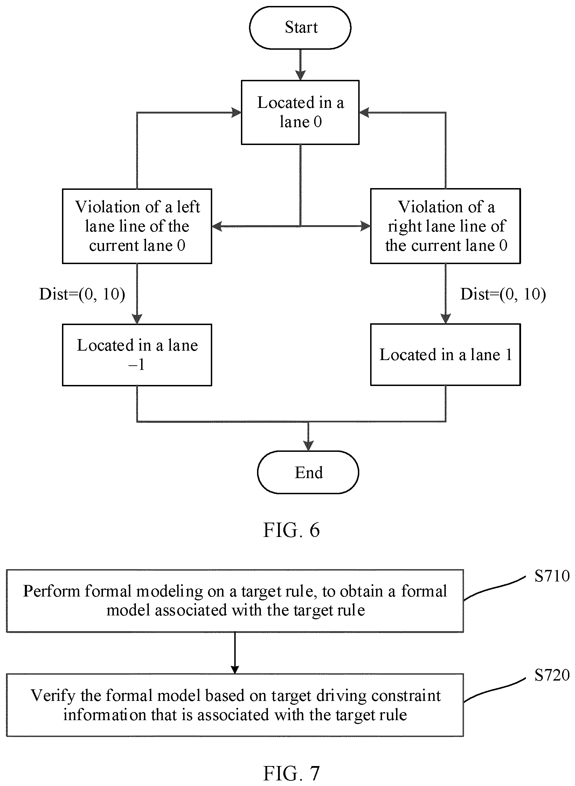

Refer to FIG. 6. The entire vehicle is used as an example. Within a rule range of the target rule, a lane in which the vehicle is currently located may be represented by a lane 0, a left adjacent lane of the lane 0 is represented by a lane -1, and a right adjacent lane of the lane 0 is represented by a lane 1. Possible states that are of associations between the ego vehicle and another traffic participant and that correspond to a case in which the vehicle conducts the candidate driving behavior of "lane change", and description of these association states by using the first candidate operator and/or the first candidate proposition may be shown in Table 1.

**Table 1**

| | |
|---|---|
| Located in a lane 0 | stPosition(InLane); stObjPosition(Behind); |
| Violation of the left lane line of the lane 0 | stCrossingLine(Ego, Left), |
| | stObjPosition(Behind&Left); |
| Located in a lane -1 | stPosition(InLane); |
| Violation of the right lane line of the lane 0 | stCrossingLine(Ego, Right), |
| | stObjPosition(Behind&Right); |
| Located in a lane 1 | stPosition(InLane); |

Before the vehicle performs the action of lane change, the ego vehicle is in an initial state and is currently located in the lane 0. In this case, the proposition "stPosition(InLane)" may be used to indicate whether the ego vehicle is located in the lane 0. For traffic safety, a safety distance between the ego vehicle and a rear target also needs to be determined when the vehicle changes lane. In this case, the proposition "stObjPosition(Behind)" can also be used to describe whether there is a vehicle behind the ego vehicle.

If the action of lane change performed by the vehicle is to change lane to the left, when the vehicle performs the action of lane change, the vehicle first needs to move to the left and cross a left lane line of the lane 0. In this case, the proposition "stCrossingLine(Ego, Left)" indicates whether the vehicle violates the left lane line of the lane 0. When the vehicle violates the left lane line of the lane 0, a safety distance between the ego vehicle and a rear vehicle in the lane -1 needs to be determined for traffic safety. Therefore, the proposition "stObjPosition(Behind&Left)" may further be used to indicate whether there is a rear vehicle in a left adjacent lane (that is, the lane - 1) of the lane 0. When the vehicle changes lane to the lane -1, the proposition "stPosition(InLane)" may be used to indicate whether the ego vehicle is in the lane -1 or not.

If the action of lane change performed by the vehicle is to change lane to the right, when the vehicle performs the action of lane change, the vehicle first needs to move to the right and cross a right lane line of the lane 0. In this case, the proposition "stCrossingLine(Ego, Right)" indicates whether the vehicle violates the right lane line of the lane 0. When the vehicle violates the right lane line of the lane 0, a safety distance between the ego vehicle and a rear target in the lane 1 needs to be determined for traffic safety. Therefore, the proposition "stObjPosition(Behind&Right)" may further be used to indicate whether there is a rear vehicle in a right adjacent lane (that is, the lane 1) of the lane 0. When the vehicle changes lane to the lane 1, the proposition "stPosition(InLane)" may be used to indicate whether the ego vehicle is in the lane 1 or not.

It should be noted that the foregoing merely describes, by using an example in which the action of lane change is the candidate driving behavior, possible association states related to the candidate driving behavior associated with the target rule. In another embodiment, a manner of determining the association state of the target rule is not limited to the parsing result of the candidate driving behavior.

S503: The vehicle control apparatus determines, based on the status information set, relationship conversion between states that are of associations between the vehicle and different traffic participants and that correspond to cases in which the vehicle conducts different candidate driving behaviors, to obtain the conversion relationship information set.

S503 may include describing a state value and a conversion relationship between the association states by using the first candidate proposition and/or the first candidate operator.

For example, in a high-speed vehicle following scenario, an ego vehicle state 1 indicates that the ego vehicle is in a same lane 3 as another vehicle, and an ego vehicle state 2 indicates that the ego vehicle is in a left lane 2 of the another vehicle. In this case, a conversion relationship for conversion from the state 1 to the state 2 may be defined as stCrossingLine(Ego, Left), that is, lane change to the left by the ego vehicle.

For example, as shown in FIG. 6, a safety distance value Dist between the vehicle and a target may be calculated in real time in a process in which the vehicle switches from the state of "violation of the left lane line of the current lane 0" to a state of "arrival at the left adjacent lane - 1 of the current lane 0".

In this way, the target model is obtained based on the status information set and the conversion relationship set that are described by using formal statements.

S430: The vehicle control apparatus determines, based on the target model, target driving constraint information associated with the target rule.

Before performing S430, the vehicle control apparatus may further obtain at least one target constraint based on the target rule, where the at least one target constraint is used to control the candidate driving behavior associated with the target rule. Refer to FIG. 5. The following steps may be further included.

S504: A second candidate proposition and/or a second candidate operator are/is obtained from the target database based on the target rule, and a calculation result of the second candidate proposition and/or a calculation result of the second candidate operator are/is determined.

The second candidate proposition and/or the second candidate operator may be in an environment category. The calculation result of the second candidate proposition and/or the calculation result of the second candidate operator may be pre-stored in the target database, or may be calculated based on the target rule.

S505: The vehicle control apparatus determines the at least one target constraint based on the calculation result of second candidate proposition and/or the calculation result of the second candidate operator.

Usually, traffic rules clearly define constraints corresponding to different association states. Therefore, the target database may further store information about a mapping relationship between a constraint and an proposition/operator that is in the environment category. Based on the calculation result of the second candidate proposition and/or the calculation result of the second candidate operator, the vehicle control apparatus may determine the at least one target constraint by looking up the mapping relationship information. For example, if it is defined in the target rule that a safety distance of 3 seconds needs to be met when the vehicle changes lane, the at least one target constraint obtained based on the target rule includes: Dist≥3 seconds.

Implementation of S430 may include the following steps.

S506: The vehicle control apparatus determines, based on the at least one target constraint and/or the target model, the target driving constraint information associated with the target rule.

In this embodiment of this application, usually, the vehicle control apparatus learns, based on the status information set, a next association state to which each association state may be switched. In addition, based on a calculation result of a proposition/operator of a current association state, conversion relationships between all propositions for a status conversion process can be obtained. Based on the target constraint, a proposition that can cause rule violation can be learned. The target driving constraint information associated with the target rule is a condition for preventing the vehicle from violating the target rule, and may be used to control the vehicle to plan a compliant path.

For example, as shown in FIG. 6, in the process in which the vehicle switches from the state of "violation of the left lane line of the current lane 0" to the state of "arrival at the left adjacent lane -1 of the current lane 0", if Dist is less than 3 seconds, a constraint on the safety distance in the target rule is not met.

Therefore, it can be learned that the target driving constraint information may include: for a current association state, a condition that Dist is less than 3 seconds and a condition that the association state is "arrival at the left adjacent lane -1 of the current lane 0" cannot be met simultaneously. A formal statement describing the target driving constraint information may be as follows:
(~stProperDist)&(X stPosition(InLane(-1)))=False

Based on the foregoing target driving constraint information, it can be learned that, if the safety distance between the vehicle and a target meets the condition that Dist is less than 3 seconds, the condition of "arrival at the left adjacent lane -1 of the current lane 0" cannot be met, in other words, the vehicle cannot change lane to the left lane -1.

Optionally, S507: The vehicle control apparatus determines, based on the at least one target constraint and/or the target model, a target assert statement associated with the target rule.

In embodiments of this application, a target assert statement may be used to describe properties that the target rule needs to contain. The properties are features that a formal statement (for example, a logic language) used to describe the target rule needs to contain. Generally, these features are the reasonableness features that need to be satisfied by the target rule.

For example, it is assumed that the target rule relates to determining of "lane change", "rear target", "safety distance", and the like. In this case, for one vehicle, the action of "lane change" can only be either of "changing lane to the left" or "changing lane to the right" at one moment. Therefore, the property of the target rule may include "a situation in which the vehicle simultaneously changes lane to the left and changes lane to the right does not occur", "a quantity of propositions containing a keyword of left equals a quantity of propositions containing a keyword of right", or the like. It is assumed that an actual safety distance value Dist is less than 3 seconds in related determining of "safety distance". Usually, actions of lane change by a vehicle need to be minimized to avoid a traffic accident. In this case, the property of the target rule may include "a situation in which both a condition that Dist is less than 3 seconds and a condition that the association state is 'arrival at the left adjacent lane -1 of the current lane 0' are met does not occur".

Further, by using the formal statement, or the foregoing first candidate proposition and/or the first candidate operator, the property may be described by using the following target assert statements:
(1) assert(Rule&(stCrossingLine(Ego, Left)&stCrossingLine(Ego, Right))==False)
(2) assert(N(Left)==N(Right))
(3) assert((~stProperDist)&(X stPosition(InLane(-1)))==False)

The target model obtained in S420, the target driving constraint information obtained in S506, and the target assert statement obtained in S507 may be stored in the storage module 210 of the vehicle control apparatus 200 while associated with the target rule.

Optionally, S440: At least one of the target model, the target driving constraint information, or the target assert statement may be provided as an output to another apparatus (for example, an autonomous vehicle) than the vehicle control apparatus 200, so that the another apparatus may implement control and management and information processing that are related to the target rule based on the at least one of the target model, the target driving constraint information, or the target assert statement, and the like.

For example, if the vehicle control apparatus 200 is configured in an ADS of an autonomous vehicle, the ADS may formulate an autonomous driving policy for the vehicle based on at least one of the target model, the target driving constraint information, or the target assert statement, and output control information for the vehicle. In this way, a trajectory of the autonomous vehicle is more reasonable and compliant.

For another example, if the vehicle control apparatus 200 is configured in a server, the ADS of the autonomous vehicle may obtain at least one of the target model, the target driving constraint information, or the target assert statement from the server, and assess, based on at least one of the target model, the target driving constraint information, or the target assert statement, a safety level of a target driving policy planned by the device for the vehicle and/or a safety level of a target driving behavior in the target driving policy. Further, S508: The vehicle control apparatus may output first indication information, where the first indication information may indicate the safety level of the target driving policy of the vehicle and/or the safety level of the target driving behavior in the target driving policy.

It should be noted that, a dashed arrow in FIG. 4 only schematically indicates that at least one of the target model, the target driving constraint information, and the target assert statement that can be obtained by the vehicle control apparatus is provided to the another apparatus than the vehicle control apparatus, but does not limit a product form of the vehicle control apparatus.

The vehicle control method in this application is described in detail with reference to the accompanying drawings and embodiments. According to the vehicle control method, finite-state machine modeling may be performed on a target rule to obtain a target model, and target driving constraint information of the target rule may be obtained by using the target model. The target driving constraint information may be used to guide an ADS of an autonomous vehicle, so that the ADS can plan a more reasonable and compliant driving policy for the vehicle. The target model and the target driving constraint information may also be used as an assessment module for traffic rules, and may be used to assess whether a driving behavior of a vehicle violates a rule, so as to further improve safety of vehicle driving.

According to the invention, the target model, the target driving constraint information, or the target assert statement is used as an assessment (or verification) module for digital traffic rules, and is used to assess (or verify) correctness and completeness of some digital traffic rules obtained in another manner. Refer to FIG. 7. The following steps are included in the verification process.

S710: The vehicle control apparatus performs formal modeling on a target rule, to obtain a formal model associated with the target rule.

Accordingly, the formal model is a model constructed by using a formal method. Thinking forms (mainly propositions and reasoning) with different content are compared to find a connective of parts of the thinking forms, for example, a connective between concepts in a proposition and a connective between propositions in reasoning. A common formal structure of the connectives is extracted, and then a symbolic language used for expressing the formal structure is introduced, so that a formal structure of a proposition or reasoning is expressed with connectives between symbols.

In S710, the vehicle control apparatus performs formal modeling on the target rule based on a specified or selected symbol language, to obtain an expected formal model. A specific form of the symbol language is not limited in this embodiment of this application. Generally, the formal model includes a formal statement expressed by using the symbol language, and the formal statement indicates whether some phenomena in the target rule are valid. Accordingly, the formal statement indicates whether the vehicle conducts a candidate driving behavior associated with the target rule, or indicates whether the vehicle violates a rule when conducting the candidate driving behavior. Therefore, the formal model may be used to control driving of the vehicle.

To ensure correctness and completeness of the formal model, S720 is included. S720: The vehicle control apparatus verifies the formal model based on a target model and/or the target driving constraint information that are/is associated with the target rule.

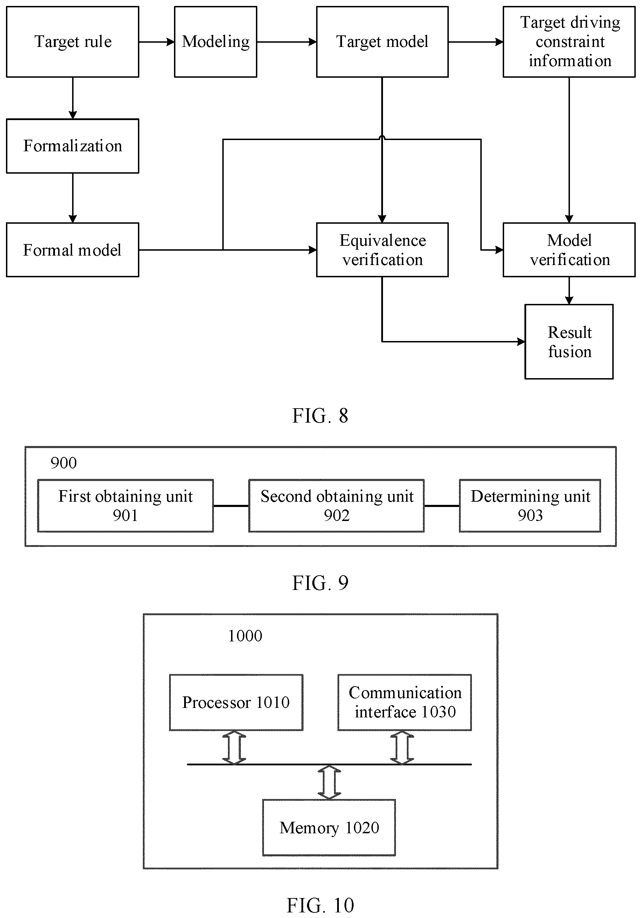

Specifically, in a schematic diagram shown in FIG. 8, in one aspect, the vehicle control apparatus may perform equivalence verification based on the target model and the formal model. In another aspect, the vehicle control apparatus may verify the formal model based on the vehicle constraint information in the target driving constraint information. Results obtained through verification in two different aspects are fused. Successful verification indicates that the formal model expresses content the same as content of the target model, correctly expresses traffic rules in the target rule, has good correctness and completeness, and can be used to control vehicle driving. Otherwise, the formal model still needs to be optimized to obtain a formal model having better correctness and completeness.

When equivalence verification is performed, whether some or all pieces of state information of the target model are consistent with outputs of the formal model may be assessed. For example, the formal model is a multi-task learning (Multi-Task Learning, MTL) model and the target model is an FSM model. At a moment t, a state of a breaking rule (breaking rule) variable in the FSM is represented as FSM(breakingrule, t), and an output of the MTL model at the moment t is expressed as ~MTL(t). FSM(breakingrule, t)=~MTL(t) is used as to-be-verified equivalence information, and equivalence verification may be performed on the formal model and the target model by using the equivalence information, to obtain an equivalence verification result. If both the two models meet the equivalence information, the equation in the equivalence information is true, which indicates that verification succeeds. The formal model on which verification succeeds may be applied to the vehicle, to obtain control information of the vehicle. Otherwise, the equation in the equivalence information is not true, and verification fails, which indicates that correctness of the formal model is insufficient. In this case, the formal model still needs to be optimized.

The vehicle constraint information may represent a condition for controlling the candidate driving behavior associated with the target rule, and/or represent an association state of an association between the vehicle and a traffic participant. In other words, the vehicle constraint information may be used to limit a property that the target rule needs to contain, and may also be used to limit a behavior conducted by the vehicle when the target rule is applied. For example, the target rule needs to contain an action that needs to be taken by the vehicle when encountering a traffic signal light, for example, waiting at a red traffic signal light and moving at a green traffic signal light. For another example, the target rule indicates a maximum speed of the vehicle, for example, 60 km/h. Modeling verification may be performed on the formal model by using the vehicle constraint information, and a model verification result can be obtained. If the formal model includes a formal statement indicating an action that needs to be taken by the vehicle when encountering a traffic signal light, it indicates that verification succeeds, and the formal model on which verification succeeds may be applied to the vehicle, to obtain the control information of the vehicle. Otherwise, verification fails, which indicates that completeness of the formal model is insufficient. In this case, the formal model still needs to be optimized.

For example, if the target rule is a rule regarding an action of lane change by a vehicle, and the target rule indicates "time for two lane changes during the action of lane change is less than delta time", the vehicle constraint information in the target driving constraint information associated with the target rule may include, for example, the following operators:
assert(ChangeLeft in MTL); and
T(ChangeLeft1)-T(ChangeLeft2)<DeltaTime.

In the foregoing operators, assert(ChangeLeft in MTL) indicates that the formal model includes an operator (ChangeLeft) for leftward lane change, T(ChangeLeft1) represents an operator for a first leftward lane change, and T(ChangeLeft2) represents an operator for a second leftward lane change. If model verification is performed on the formal model by using the foregoing vehicle constraint information, the formal model needs to include a formal statement equivalent to the foregoing operator so that verification can succeed; otherwise, verification fails. In other words, if the formal model does not include the formal statement having the foregoing meaning, completeness of the formal model is insufficient, and the formal model needs to be optimized.

It may be understood that the foregoing verification process is merely an example for describing a formal verification manner in this embodiment of this application, but does not constitute any limitation. In another embodiment, verification logic of the vehicle control apparatus may be further configured based on an application scenario or a service requirement, to rigorously and efficiently ensure correctness and completeness of the established formal model. A specific implementation of the verification process is not limited in this embodiment of this application. In addition, when only the target model is obtained, in this embodiment of this application, the target driving constraint information and/or the target assert statement may be obtained based on the target model by performing the foregoing method steps. In the foregoing verification process, used information includes but is not limited to the target driving constraint information, and may further include other information obtained based on the target model. Details are not described herein again.

Further, the vehicle control apparatus may output control information of the vehicle based on the formal model on which verification succeeds. For example, the formal model on which verification succeeds may be deployed in an ADS of the vehicle, and the ADS may formulate a target driving policy for the vehicle based on the formal model on which verification succeeds, and output the control information of the vehicle. Alternatively, the vehicle control apparatus may assess, based on the formal model on which verification succeeds, safety of the target driving policy formulated by the vehicle control apparatus for the vehicle, and output second indication information, where the second indication information indicates a safety level of the target driving policy of the vehicle and/or a safety level of a target driving behavior in the target driving policy. In this way, the ADS can plan a more reasonable and compliant driving policy for the vehicle based on the target driving constraint information.

Therefore, according to the foregoing verification process, the vehicle control apparatus may use the target model and the target driving constraint information in this embodiment of this application as an assessment (or verification) module for a digital traffic rule or the formal model. This helps to rigorously and efficiently ensure correctness and completeness of the established formal model. The method may also be used to abstract a complex system (for example, the ADS) into a simple formal model, and verify correctness and completeness of the formal model by using relatively correct and complete target driving constraint information of the target model described above. In this way, complexity is simplified. This facilitates verification of correctness and completeness of the ADS, so that the formal verification process can be less complicated.

An embodiment of this application further provides a vehicle control apparatus, configured to perform the method performed by the vehicle control apparatus in the foregoing method embodiment. For related features, refer to the foregoing method embodiment. Details are not described herein again.

As shown in FIG. 9, the vehicle control apparatus 900 may include: a first obtaining unit 901, configured to obtain a target rule; a second obtaining unit 902, configured to obtain a target model based on the target rule, where the target rule is associated with a candidate driving behavior of a vehicle, the target model includes a status information set and a conversion relationship information set, state information in the status information set describes a state that is of an association between the vehicle and another traffic participant and that corresponds to a case in which the vehicle conducts the candidate driving behavior, and conversion relationship information in the conversion relationship information set describes a conversion relationship between different association states; and a determining unit 903, configured to determine, based on the target model, target driving constraint information associated with the target rule.

Optionally, the second obtaining unit 902 is configured to: parse the candidate driving behavior, and determine the state that is of the association between the vehicle and the another corresponding traffic participant and that corresponds to the case in which the vehicle conducts the candidate driving behavior, to obtain the status information set; determine, based on the status information set, relationship conversion between states that are of associations between the vehicle and different traffic participants and that correspond to cases in which the vehicle conducts different candidate driving behaviors, to obtain the conversion relationship information set; and obtain the target model based on the status information set and the conversion relationship information set.

Optionally, the association state includes one or more of the following: a running state of a software module or a hardware module of the vehicle; a running state of a software module or a hardware module of the another traffic participant; an environment state of an environment in which the vehicle and the another traffic participant are located; and an association relationship between the software module or the hardware module of the vehicle and the software module or the hardware module of the another traffic participant.

Optionally, the conversion relationship between different association states includes one or more of the following: a relationship of conversion from a first running state to a second running state by the software module or the hardware module of the vehicle; a relationship of conversion from a third running state to a fourth running state by the software module or the hardware module of the another traffic participant; a relationship of environment state conversion that is of the environment in which the vehicle and the another traffic participant are located and that is from a fifth state to a sixth state; and a relationship of conversion from a first association relationship to a second association relationship by the software module or the hardware module of the vehicle and the software module or the hardware module of the another traffic participant.

Optionally, the second obtaining unit 902 is further configured to: obtain a first candidate proposition and/or a first candidate operator from a target database; and describe the state information in the status information set and the conversion relationship information in the conversion relationship information set by using the first candidate proposition and/or the first candidate operator.

Optionally, the second obtaining unit 902 is configured to: obtain at least one target constraint based on the target rule, where the at least one target constraint is used to control the candidate driving behavior associated with the target rule; and determine, based on the at least one target constraint and/or the target model, the target driving constraint information associated with the target rule.

Optionally, the at least one target constraint includes one or more of the following: a vehicle state constraint, a driving action constraint, or a safety distance constraint.

Optionally, the second obtaining unit 902 is further configured to: obtain a second candidate proposition and/or a second candidate operator from the target database; and describe the at least one target constraint by using the second candidate proposition and/or the second candidate operator.

Optionally, the apparatus further includes a first output unit, configured to output control information of the vehicle based on the target driving constraint information.

Optionally, the apparatus further includes a second output unit, configured to output first indication information based on the target driving constraint information, where the first indication information indicates a safety level of a target driving policy of the vehicle and/or a safety level of a target driving behavior in the target driving policy.

The apparatus further includes: a modeling unit, configured to perform formal modeling on the target rule to obtain a formal model associated with the target rule, where the formal model includes a formal statement, and the formal statement indicates whether the vehicle conducts the candidate driving behavior, or indicates whether the vehicle violates a rule when conducting the candidate driving behavior; and a verification unit, configured to verify the formal model based on the target model and/or the target driving constraint information that are/is associated with the target rule.

Optionally, the verification unit is specifically configured to: perform equivalence verification based on the target model and the formal model, where the equivalence verification is used to verify whether the state information in the status information set of the target model is equivalent to an output of the formal model.

Optionally, the verification unit is specifically configured to: verify the formal model based on vehicle constraint information in the target driving constraint information, where the vehicle constraint information represents a condition for controlling the candidate driving behavior associated with the target rule, and/or represents a state that is of an association between the vehicle and a traffic participant.

Optionally, the apparatus further includes a third output unit, configured to output control information of the vehicle based on the formal model on which verification succeeds.

Optionally, the apparatus further includes a fourth output unit, configured to output second indication information based on the formal model on which verification succeeds, where the second indication information indicates a safety level of a target driving policy of the vehicle and/or a safety level of the target driving behavior in the target driving policy.

It should be noted that, in embodiments of this application, unit division is example division and is merely logical function division. There may be other division in an actual implementation. The functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of a software functional unit and is sold or used as an independent product, the integrated unit may be stored in a computer-readable storage medium. Based on such an understanding, the technical solutions of this application essentially, or the part contributing to the conventional art, or all or some of the technical solutions may be implemented in the form of a software product. The computer software product is stored in a storage medium and includes several instructions for instructing a computer device (which may be a personal computer, a server, or a network device) or a processor (processor) to perform all or some of the steps of the methods described in embodiments of this application. The foregoing storage medium includes any medium that can store program code, for example, a USB flash drive, a removable hard disk, a read-only memory (ROM, Read-Only Memory), a random access memory (RAM, Random Access Memory), a magnetic disk, or an optical disc.

In a simple embodiment, a person skilled in the art may figure out that the vehicle control apparatus or the vehicle in the foregoing embodiments may be in a form shown in FIG. 10.

An apparatus 1000 shown in FIG. 10 includes at least one processor 1010 and a memory 1020. Optionally, the apparatus 1000 may further include a communication interface 1030.

The memory 1020 may be a volatile memory, for example, a random access memory, or the memory may be a non-volatile memory, for example, a read-only memory, a flash memory, a hard disk drive (hard disk drive, HDD), or a solid-state drive (solid-state drive, SSD), or the memory 1020 is any other medium that can be used to carry or store expected program code in a form of an instruction or a data structure and that can be accessed by a computer. The memory 1020 is not limited thereto. The memory 1020 may be a combination of the foregoing memories.

A specific connection medium between the processor 1010 and the memory 1020 is not limited in this embodiment of this application.

The apparatus shown in FIG. 10 further includes a communication interface 1030. When communicating with another device, the processor 1010 may transmit data through the communication interface 1030.

When the vehicle control apparatus is in the form shown in FIG. 10, the processor 1010 in FIG. 10 may invoke computer-executable instructions stored in the memory 1020, so that the apparatus 1000 can perform the method performed by the vehicle control apparatus in any one of the foregoing method embodiments.

When the vehicle is in the form shown in FIG. 10, the processor 1010 in FIG. 10 may invoke computer-executable instructions stored in the memory 1020, so that the apparatus 1000 can perform the method performed by the vehicle in any one of the foregoing method embodiments.

An embodiment of this application further relates to a chip system. The chip system includes a processor, configured to invoke a computer program or computer instructions stored in a memory, so that the processor performs the method shown in any one of the embodiments in FIG. 4 and FIG. 5.

In a possible implementation, the processor is coupled to the memory through an interface.

In a possible implementation, the chip system further includes a memory, and the memory stores a computer program or computer instructions.

An embodiment of this application further relates to a processor. The processor is configured to invoke a computer program or computer instructions stored in a memory, so that the processor performs the method shown in any one of the embodiments in FIG. 4 and FIG. 5.

Any processor mentioned above may be a general-purpose central processing unit, a microprocessor, an application-specific integrated circuit (application-specific integrated circuit, ASIC), or one or more integrated circuits configured to control program execution of the vehicle control method in the embodiment shown in FIG. 4 or FIG. 5. Any memory mentioned above may be a read-only memory (read-only memory, ROM) or another type of static storage device that can store static information and instructions, a random access memory (random access memory, RAM), or the like.

It should be understood that embodiments of this application may be provided as a method, a system, or a computer program product. Therefore, this application may take the form of hardware only embodiments, software only embodiments, or embodiments with a combination of software and hardware. In addition, this application may take the form of a computer program product implemented on one or more computer-usable storage media (including but not limited to a disk memory, a CD-ROM, an optical memory, and the like) that include computer-usable program code.

These computer program instructions may alternatively be stored in a computer-readable memory that can indicate the computer or another programmable data processing device to work in a specific manner, so that the instructions stored in the computer-readable memory generate an artifact that includes an instruction apparatus. The instruction apparatus implements a specific function in one or more procedures in the flowcharts and/or in one or more blocks in the block diagrams.

These computer program instructions may alternatively be loaded onto the computer or the another programmable data processing device, so that a series of operations and steps are performed on the computer or the another programmable device to generate computer-implemented processing. In this case, the instructions executed on the computer or the another programmable device provide steps for implementing a specific function in one or more procedures in the flowcharts and/or in one or more blocks in the block diagrams.

## Claims

1. A vehicle control method, applied to a vehicle control apparatus, the vehicle control method comprising:
obtaining (S410) a target rule;
obtaining (S420) a target model based on the target rule, wherein the target rule is associated with a candidate driving behavior of a vehicle, the target model comprises a status information set and a conversion relationship information set,
wherein the state information in the status information set describes a state that is of an association between the vehicle and another traffic participant and that corresponds to a case in which the vehicle conducts the candidate driving behavior, and conversion relationship information in the conversion relationship information set describes a conversion relationship between different association states; and in that the method further comprises:
determining (S430), based on the target model, target driving constraint information associated with the target rule,
wherein the method further comprises:
performing formal modeling on the target rule to obtain a formal model associated with the target rule, wherein the formal model comprises a formal statement, and the formal statement indicates whether the vehicle conducts the candidate driving behavior, or indicates whether the vehicle violates a rule when conducting the candidate driving behavior;
**characterized in that** the method further comprises:
verifying the formal model based on the target model and/or the target driving constraint information that are/is associated with the target rule.

2. The method according to claim 1, wherein the obtaining a target model based on the target rule comprises:
parsing the candidate driving behavior, and determining the state that is of the association between the vehicle and the another corresponding traffic participant and that corresponds to the case in which the vehicle conducts the candidate driving behavior, to obtain the status information set;
determining, based on the status information set, relationship conversion between states that are of associations between the vehicle and different traffic participants and that correspond to cases in which the vehicle conducts different candidate driving behaviors, to obtain the conversion relationship information set; and
obtaining the target model based on the status information set and the conversion relationship information set.

3. The method according to claim 1 or 2, wherein the association state comprises one or more of the following:
a running state of a software module or a hardware module of the vehicle;
a running state of a software module or a hardware module of the another traffic participant;
an environment state of an environment in which the vehicle and the another traffic participant are located;
an association relationship between the software module of the vehicle and the software module of the another traffic participant,
an association relationship between the software module of the vehicle and the hardware module of the another traffic participant,
an association relationship between the hardware module of the vehicle and the software module of the another traffic participant, and
an association relationship between the hardware module of the vehicle and the hardware module of the another traffic participant.

4. The method according to claim 3, wherein the conversion relationship between different association states comprises one or more of the following:
a relationship of conversion from a first running state to a second running state by the software module or the hardware module of the vehicle;
a relationship of conversion from a third running state to a fourth running state by the software module or the hardware module of the another traffic participant;
a relationship of environment state conversion that is of the environment in which the vehicle and the another traffic participant are located and that is from a fifth state to a sixth state; and
a relationship of conversion from a first association relationship to a second association relationship by the software module or the hardware module of the vehicle and the software module or the hardware module of the another traffic participant.

5. The method according to any one of claims 1 to 4, wherein the method further comprises:
obtaining a first candidate proposition and/or a first candidate operator from a target database; and
describing the state information in the status information set and the conversion relationship information in the conversion relationship information set by using the first candidate proposition and/or the first candidate operator.

6. The method according to any one of claims 1 to 5, wherein the method further comprises:
obtaining at least one target constraint based on the target rule, wherein the at least one target constraint is used to control the candidate driving behavior associated with the target rule; and
the determining, based on the target model, target driving constraint information associated with the target rule comprises:
determining, based on the at least one target constraint and/or the target model, the target driving constraint information associated with the target rule.

7. The method according to claim 6, wherein the at least one target constraint comprises one or more of the following: a vehicle state constraint, a driving action constraint, or a safety distance constraint.

8. The method according to claim 6 or 7, wherein the method further comprises:
obtaining a second candidate proposition and/or a second candidate operator from the target database; and
describing the at least one target constraint by using the second candidate proposition and/or the second candidate operator.

9. The method according to any one of claims 1 to 8, wherein the method further comprises:
outputting control information of the vehicle based on the target driving constraint information.

10. The method according to any one of claims 1 to 8, wherein there is a target driving policy of the vehicle and the method further comprises:
outputting first indication information based on the target driving constraint information, wherein the first indication information indicates a safety level of the target driving policy of the vehicle and/or a safety level of a target driving behavior in the target driving policy.

11. The method according to any one of claims 1 to 10, wherein the verifying the formal model based on the target model that is associated with the target rule comprises:
performing equivalence verification based on the target model and the formal model, wherein the equivalence verification is used to verify whether the state information in the status information set of the target model is equivalent to an output of the formal model.

12. The method according to any one of claims 1 to 11, wherein the verifying the formal model based on the target driving constraint information that is associated with the target rule comprises:
verifying the formal model based on vehicle constraint information in the target driving constraint information, wherein the vehicle constraint information represents a condition for controlling the candidate driving behavior associated with the target rule, and/or represents a state that is of an association between the vehicle and a traffic participant.

13. A vehicle control apparatus, configured to implement the method according to any one of claims 1 to 12.

14. A vehicle, wherein the vehicle comprises the vehicle control apparatus of claim 13.

15. A computer-readable storage medium, wherein the computer-readable storage medium stores a computer program, and when the computer program is run on a computer, the computer is enabled to perform the method according to any one of claims 1 to 12.

## Patentansprüche

1. Fahrzeugsteuerungsverfahren, das in einer Fahrzeugsteuerungsvorrichtung angewandt wird, wobei das Fahrzeugsteuerungsverfahren umfasst:
Erhalten (S410) einer Zielregel;
Erhalten (S420) eines Zielmodells basierend auf der Zielregel, wobei die Zielregel mit einem Kandidatenfahrverhalten eines Fahrzeugs assoziiert ist, wobei das Zielmodell einen Zustandsinformationssatz und einen Informationssatz von Umwandlungsbeziehungen umfasst,
wobei die Zustandsinformationen in dem Zustandsinformationssatz einen Zustand beschreiben, der zu einem Zusammenhang zwischen dem Fahrzeug und einem anderen Verkehrsteilnehmer gehört und der einem Fall entspricht, in dem das Fahrzeug in dem Kandidatenfahrverhalten fährt, und wobei Umwandlungsbeziehungsinformationen in dem Informationssatz von Umwandlungsbeziehungen eine Umwandlungsbeziehung zwischen verschiedenen Zuständen von Zusammenhängen beschreiben; und wobei das Verfahren ferner umfasst:
Ermitteln (S430), basierend auf dem Zielmodell, von Informationen über Zielfahrbedingungen, die mit der Zielregel in Zusammenhang stehen,
wobei das Verfahren ferner umfasst:
Durchführen einer formalen Modellierung an der Zielregel, um ein formales Modell zu erhalten, das mit der Zielregel in Zusammenhang steht, wobei das formale Modell eine formale Aussage umfasst und wobei die formale Aussage anzeigt, ob das Fahrzeug in dem Kandidatenfahrverhalten fährt, oder anzeigt, ob das Fahrzeug eine Regel verletzt, wenn es in dem Kandidatenfahrverhalten fährt;
**dadurch gekennzeichnet, dass** das Verfahren ferner umfasst:
Verifizieren des formalen Modells basierend auf dem Zielmodell und/oder den Informationen über Zielfahrbedingungen, die mit der Zielregel in Zusammenhang stehen.

2. Verfahren nach Anspruch 1, wobei das Erhalten eines Zielmodells basierend auf der Zielregel umfasst:
Analysieren des Kandidatenfahrverhaltens und Ermitteln des Zustands, der zu dem Zusammenhang zwischen dem Fahrzeug und dem anderen entsprechenden Verkehrsteilnehmer gehört und der dem Fall entspricht, in dem das Fahrzeug in dem Kandidatenfahrverhalten fährt, um den Zustandsinformationssatz zu erhalten;
Ermitteln, basierend auf dem Zustandsinformationssatz, einer Beziehungsumwandlung zwischen Zuständen, die zu den Zusammenhängen zwischen dem Fahrzeug und unterschiedlichen Verkehrsteilnehmern gehören und die den Fällen entsprechen, in denen das Fahrzeug in unterschiedlichen Kandidatenfahrverhalten fährt, um den Informationssatz von Umwandlungsbeziehungen zu erhalten; und
Erhalten des Zielmodells basierend auf dem Zustandsinformationssatz und dem Informationssatz von Umwandlungsbeziehungen.

3. Verfahren nach Anspruch 1 oder 2, wobei der Zustand von Zusammenhängen einen oder mehrere der Folgenden umfasst:
einen Ausführungszustand eines Softwaremoduls oder eines Hardwaremoduls des Fahrzeugs;
einen Ausführungszustand eines Softwaremoduls oder eines Hardwaremoduls des anderen Verkehrsteilnehmers;
einen Umgebungszustand einer Umgebung, in der sich das Fahrzeug und der andere Verkehrsteilnehmer befinden;
eine Beziehung des Zusammenhangs zwischen dem Softwaremodul des Fahrzeugs und dem Softwaremodul des anderen Verkehrsteilnehmers,
eine Beziehung des Zusammenhangs zwischen dem Softwaremodul des Fahrzeugs und dem Hardwaremodul des anderen Verkehrsteilnehmers,
eine Beziehung des Zusammenhangs zwischen dem Hardwaremodul des Fahrzeugs und dem Softwaremodul des anderen Verkehrsteilnehmers, und
eine Beziehung des Zusammenhangs zwischen dem Hardwaremodul des Fahrzeugs und dem Hardwaremodul des anderen Verkehrsteilnehmers.

4. Verfahren nach Anspruch 3, wobei die Umwandlungsbeziehung zwischen unterschiedlichen Zuständen von Zusammenhängen eine oder mehrere der Folgenden umfasst:
eine Beziehung einer Umwandlung von einem ersten Ausführungszustand in einen zweiten Ausführungszustand durch das Softwaremodul oder das Hardwaremodul des Fahrzeugs;
eine Beziehung einer Umwandlung von einem dritten Ausführungszustand in einen vierten Ausführungszustand durch das Softwaremodul oder das Hardwaremodul des anderen Verkehrsteilnehmers;
eine Beziehung einer Umgebungszustandsumwandlung, die zu der Umgebung gehört, in der sich das Fahrzeug und der andere Verkehrsteilnehmer befinden und die von einem fünften Zustand in einen sechsten Zustand erfolgt; und
eine Beziehung einer Umwandlung von einer ersten Beziehung eines Zusammenhangs zu einer zweiten Beziehung eines Zusammenhangs durch das Softwaremodul oder das Hardwaremodul des Fahrzeugs und das Softwaremodul oder das Hardwaremodul des anderen Verkehrsteilnehmers.

5. Verfahren nach einem der Ansprüche 1 bis 4, wobei das Verfahren ferner umfasst: Erhalten einer ersten Kandidatenproposition und/oder eines ersten Kandidatenoperators aus einer Zieldatenbank; und
Beschreiben der Zustandsinformationen in dem Zustandsinformationssatz und der Umwandlungsbeziehungsinformationen in dem Informationssatz von Umwandlungsbeziehungen, indem die erste Kandidatenproposition und/oder der erste Kandidatenoperator verwendet werden.

6. Verfahren nach einem der Ansprüche 1 bis 5, wobei das Verfahren ferner umfasst:
Erhalten mindestens einer Zielbedingung basierend auf der Zielregel, wobei die mindestens eine Zielbedingung verwendet wird, um das Kandidatenfahrverhalten zu steuern, das mit der Zielregel in Zusammenhang steht; und
wobei das Ermitteln, basierend auf dem Zielmodell, von Informationen über Zielfahrbedingungen, die mit der Zielregel in Zusammenhang stehen, umfasst:
Ermitteln, basierend auf der mindestens einen Zielbedingung und/oder dem Zielmodell, der Informationen über Zielfahrbedingungen, die mit der Zielregel in Zusammenhang stehen.

7. Verfahren nach Anspruch 6, wobei die mindestens eine Zielbedingung eine oder mehrere der Folgenden umfasst: eine Fahrzeugzustandsbedingung, eine Fahraktionsbedingung oder eine Sicherheitsabstandsbedingung.

8. Verfahren nach Anspruch 6 oder 7, wobei das Verfahren ferner umfasst:
Erhalten einer zweiten Kandidatenproposition und/oder eines zweiten Kandidatenoperators aus der Zieldatenbank; und
Beschreiben der mindestens einen Zielbedingung, indem die zweite Kandidatenproposition und/oder der zweite Kandidatenoperator verwendet werden.

9. Verfahren nach einem der Ansprüche 1 bis 8, wobei das Verfahren ferner umfasst:
Ausgeben von Steuerinformationen des Fahrzeugs basierend auf den Informationen über Zielfahrbedingungen.

10. Verfahren nach einem der Ansprüche 1 bis 8, wobei eine Zielfahrrichtlinie des Fahrzeugs vorhanden ist und wobei das Verfahren ferner umfasst:
Ausgeben von ersten Anzeigeinformationen basierend auf den Informationen über Zielfahrbedingungen, wobei die ersten Anzeigeinformationen ein Sicherheitsniveau der Zielfahrrichtlinie des Fahrzeugs und/oder ein Sicherheitsniveau eines Zielfahrverhaltens in der Zielfahrrichtlinie anzeigen.

11. Verfahren nach einem der Ansprüche 1 bis 10, wobei das Verifizieren des formalen Modells basierend auf dem Zielmodell, das mit der Zielregel in Zusammenhang steht, umfasst:
Durchführen einer Äquivalenzverifizierung basierend auf dem Zielmodell und dem formalen Modell, wobei die Äquivalenzverifizierung verwendet wird, um zu verifizieren, ob die Zustandsinformationen in dem Zustandsinformationssatz des Zielmodells äquivalent zu einer Ausgabe des formalen Modells sind.

12. Verfahren nach einem der Ansprüche 1 bis 11, wobei das Verifizieren des formalen Modells basierend auf den Informationen über Zielfahrbedingungen, die mit der Zielregel in Zusammenhang stehen, umfasst:
Verifizieren des formalen Modells basierend auf Fahrzeugbedingungsinformationen in den Informationen über Zielfahrbedingungen, wobei die Fahrzeugbedingungsinformationen eine Vorbedingung zum Steuern des Kandidatenfahrverhaltens repräsentieren, das mit der Zielregel in Zusammenhang steht, und/oder einen Zustand repräsentieren, der zu einem Zusammenhang zwischen dem Fahrzeug und einem Verkehrsteilnehmer gehört.

13. Fahrzeugsteuerungsvorrichtung, die konfiguriert ist, um das Verfahren nach einem der Ansprüche 1 bis 12 zu implementieren.

14. Fahrzeug, wobei das Fahrzeug die Fahrzeugsteuerungsvorrichtung nach Anspruch 13 umfasst.

15. Computerlesbares Speichermedium, wobei in dem computerlesbaren Speichermedium ein Computerprogramm gespeichert ist und wobei, wenn das Computerprogramm in einem Computer ausgeführt wird, der Computer aktiviert wird, um das Verfahren nach einem der Ansprüche 1 bis 12 durchzuführen.

## Revendications

1. Procédé de commande de véhicule, appliqué à un équipement de commande de véhicule, le procédé de commande de véhicule comprenant les étapes suivantes :
obtenir (S410) une règle cible ;
obtenir (S420) un modèle cible basé sur la règle cible, la règle cible étant associée à un comportement de conduite candidat d'un véhicule, le modèle cible comprenant un ensemble d'informations d'état et un ensemble d'informations de relation de conversion,
où les informations d'état dans l'ensemble d'informations d'état décrivent un état d'une association entre le véhicule et un autre participant au trafic et qui correspond à un cas dans lequel le véhicule exécute le comportement de conduite candidat, et les informations de relation de conversion dans l'ensemble d'informations de relation de conversion décrivent une relation de conversion entre différents états d'association ; le procédé comprenant en outre :
de déterminer (S430), sur la base du modèle cible, des informations de contrainte de conduite cibles associées à la règle cible,
le procédé comprenant en outre :
d'exécuter une modélisation formelle sur la règle cible afin d'obtenir un modèle formel associé à la règle cible, le modèle formel comprenant un énoncé formel, et l'énoncé formel indiquant si le véhicule exécute le comportement de conduite candidat, ou indiquant si le véhicule enfreint une règle lors de l'exécution du comportement de conduite candidat ;
**caractérisé en ce que** le procédé comprend en outre :
de vérifier le modèle formel sur la base du modèle cible et/ou des informations de contrainte de conduite cibles qui sont associées à la règle cible.

2. Procédé selon la revendication 1, dans lequel l'obtention d'un modèle cible sur la base de la règle cible comprend les étapes suivantes :
analyser le comportement de conduite candidat, et déterminer l'état de l'association entre le véhicule et l'autre participant au trafic correspondant et qui correspond au cas dans lequel le véhicule exécute le comportement de conduite candidat, afin d'obtenir l'ensemble d'informations d'état ;
déterminer, sur la base de l'ensemble d'informations d'état, une conversion de relation entre des états d'associations entre le véhicule et différents participants au trafic et qui correspondent à des cas dans lesquels le véhicule exécute différents comportements de conduite candidats, afin d'obtenir l'ensemble d'informations de relation de conversion ; et
obtenir le modèle cible sur la base de l'ensemble d'informations d'état et de l'ensemble d'informations de relation de conversion.

3. Procédé selon la revendication 1 ou la revendication 2, dans lequel l'état d'association comprend un ou plusieurs des états suivants :
un état de fonctionnement d'un module logiciel ou d'un module matériel du véhicule ;
un état de fonctionnement d'un module logiciel ou d'un module matériel de l'autre participant au trafic ;
un état d'environnement d'un environnement dans lequel se trouvent le véhicule et l'autre participant au trafic ;
une relation d'association entre le module logiciel du véhicule et le module logiciel de l'autre participant au trafic,
une relation d'association entre le module logiciel du véhicule et le module matériel de l'autre participant au trafic,
une relation d'association entre le module matériel du véhicule et le module logiciel de l'autre participant au trafic, et
une relation d'association entre le module matériel du véhicule et le module matériel de l'autre participant au trafic.

4. Procédé selon la revendication 3, dans lequel la relation de conversion entre différents états d'association comprend l'une ou plusieurs des relations suivantes :
une relation de conversion d'un premier état de fonctionnement à un deuxième état de fonctionnement par le module logiciel ou le module matériel du véhicule ;
une relation de conversion d'un troisième état de fonctionnement à un quatrième état de fonctionnement par le module logiciel ou le module matériel de l'autre participant au trafic ;
une relation de conversion d'état d'environnement de l'environnement dans lequel le véhicule et l'autre participant au trafic sont situés et d'un cinquième état à un sixième état ; et
une relation de conversion d'une première relation d'association à une deuxième relation d'association par le module logiciel ou le module matériel du véhicule et le module logiciel ou le module matériel de l'autre participant au trafic.

5. Procédé selon l'une quelconque des revendications 1 à 4, dans lequel le procédé comprend en outre les étapes suivantes : obtenir une première proposition candidate et/ou un premier opérateur candidat auprès d'une base de données cible ; et
décrire les informations d'état dans l'ensemble d'informations d'état et les informations de relation de conversion dans l'ensemble d'informations de relation de conversion en utilisant la première proposition candidate et/ou le premier opérateur candidat.

6. Procédé selon l'une quelconque des revendications 1 à 5, le procédé comprenant en outre les étapes suivantes :
obtenir au moins une contrainte cible sur la base de la règle cible, l'au moins une contrainte cible étant utilisée pour commander le comportement de conduite candidat associé à la règle cible ; et
la détermination, sur la base du modèle cible, des informations de contrainte de conduite cibles, associées à la règle cible, comprend :
de déterminer, sur la base de l'au moins une contrainte cible et/ou du modèle cible, les informations de contrainte de conduite cibles associées à la règle cible.

7. Procédé selon la revendication 6, dans lequel l'au moins une contrainte cible comprend une ou plusieurs des contraintes suivantes : une contrainte d'état de véhicule, une contrainte d'action de conduite, ou une contrainte de distance de sécurité.

8. Procédé selon la revendication 6 ou la revendication 7, le procédé comprenant en outre les étapes suivantes :
obtenir une deuxième proposition candidate et/ou un deuxième opérateur candidat auprès de la base de données cible ; et
décrire l'au moins une contrainte cible en utilisant la deuxième proposition candidate et/ou le deuxième opérateur candidat.

9. Procédé selon l'une quelconque des revendications 1 à 8, le procédé comprenant en outre de délivrer en sortie des informations de commande du véhicule sur la base des informations de contrainte de conduite cibles.

10. Procédé selon l'une quelconque des revendications 1 à 8, dans lequel il existe une politique de conduite cible du véhicule et le procédé comprend en outre l'étape suivante :
délivrer en sortie des premières informations d'indication sur la base des informations de contrainte de conduite cibles, les premières informations d'indication indiquant un niveau de sécurité de la politique de conduite cible du véhicule et/ou un niveau de sécurité d'un comportement de conduite cible dans la politique de conduite cible.

11. Procédé selon l'une quelconque des revendications 1 à 10, dans lequel la vérification du modèle formel sur la base du modèle cible qui est associé à la règle cible comprend l'étape suivante :
réaliser une vérification d'équivalence sur la base du modèle cible et du modèle formel, la vérification d'équivalence étant utilisée pour vérifier si les informations d'état dans l'ensemble d'informations d'état du modèle cible sont équivalentes à une sortie du modèle formel.

12. Procédé selon l'une quelconque des revendications 1 à 11, dans lequel la vérification du modèle formel sur la base des informations de contrainte de conduite cibles qui sont associées à la règle cible comprend l'étape suivante :
vérifier le modèle formel sur la base d'informations de contrainte de véhicule dans les informations de contrainte de conduite cibles, les informations de contrainte de véhicule représentant une condition de commande du comportement de conduite candidat associé à la règle cible, et/ou représentant un état d'association entre le véhicule et un participant au trafic.

13. Appareil de commande de véhicule, configuré pour mettre en œuvre le procédé selon l'une quelconque des revendications 1 à 12.

14. Véhicule, où le véhicule comprend l'appareil de commande de véhicule selon la revendication 13.

15. Support de stockage lisible par ordinateur, le support de stockage lisible par ordinateur stockant un programme informatique et, lorsque le programme informatique est exécuté sur un ordinateur, l'ordinateur pouvant exécuter le procédé selon l'une quelconque des revendications 1 à 12.
